(19) Europäisches Patentamt
European Patent Office
Office européen des brevets

(11) Publication number : 0 287 212 B1

(12) # EUROPEAN PATENT SPECIFICATION

(45) Date of publication of patent specification : **28.12.94 Bulletin 94/52**

(51) Int. Cl.$^5$ : **G03F 7/023**

(21) Application number : **88302171.9**

(22) Date of filing : **11.03.88**

(54) **Positive photosensitive planographic printing plate.**

(30) Priority : **12.03.87 JP 57282/87
07.05.87 JP 111413/87
18.05.87 JP 120592/87
03.06.87 JP 139140/87**

(43) Date of publication of application : **19.10.88 Bulletin 88/42**

(45) Publication of the grant of the patent : **28.12.94 Bulletin 94/52**

(84) Designated Contracting States : **DE FR GB**

(56) References cited :
**EP-A- 0 184 044
DE-A- 2 352 139
FR-A- 2 211 677
JP-A-52 028 401
US-A- 4 009 033
US-A- 4 036 644
J. KOSAR : "LIGHT-SENSITIVE SYSTEMS", 1965, JOHN WILEY & SONS, NEW YORK, US.
IBM TECHNICAL DISCLOSURE BULLETIN, vol. 25, no. 3A, August 1982, page 983, New York, US; A.L. THAYER, JR.: "Contrast enhancement in positive working resist systems"
RESEARCH DISCLOSURE, no. 149, September 1976, pages 27-29, ref. no. 14929, Havant, Hampshire, GB; R.H. ENGEBRECHT: "Photoresists containing quinone diazides"**

(73) Proprietor : **MITSUBISHI KASEI CORPORATION
5-2, Marunouchi 2-chome
Chiyoda-ku
Tokyo 100 (JP)**
Proprietor : **KONICA CORPORATION
26-2, Nishishinjuku 1-chome,
Shinjuku-ku
Tokyo 160 (JP)**

(72) Inventor : **Tomiyasu, Hiroshi
2-11-1 Ogawa
Machida-shi Tokyo (JP)**
Inventor : **Kobayashi, Yoshiko
2-31-5 Shin-Ishikawa
Midori-ku
Yokohama-shi Kanagawa-ken (JP)**
Inventor : **Goto, Kiyoshi
1210-109 Kunugida-cho
Hachioji-shi Tokyo (JP)**
Inventor : **Yamamoto, Takeshi
3-2-15-209 Mure
Mitaka-shi Tokyo (JP)**
Inventor : **Nakai, Hideyuki
6-5-2 Tamadaira
Hino-shi Tokyo (JP)**

(74) Representative : **Woods, Geoffrey Corlett et al
J.A. KEMP & CO.
14 South Square
Gray's Inn
London WC1R 5LX (GB)**

EP 0 287 212 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to positive planographic printing plates.

Generally, a positive photosensitive planographic printing plate has, on a hydrophilic support, an ink receptive photosensitive layer which is solubilized upon exposure. When this photosensitive layer is imagewise exposed and developed, the non-image area of the layer is removed, with the image area alone being left, to form the image on the plate. Printing with the printing plate is conducted by taking advantage of the difference in properties between the image area and the non-image area, the former being lipophilic and the latter hydrophilic.

Generally, planographic printing plates are required to have properties such as high printing durability, chemical resistance, great latitude in development, good ink receptivity and high sensitivity. Especially the positive type needs to have exceptionally high chemical resistance, excellent printing durability and great latitude in development. The term "chemical resistance" used here refers to the resistance to various types of chemicals used in printing operations, such as isopropyl alcohol, ink, affinitising solution and plate cleaner.

o-Naphthoquinonediazido compounds are popularly used for the photosensitive layer. Since these compounds, however, are not polymeric compounds, they are usually mixed or reacted in a condensation reaction with, for example, novolak resins to elevate the mechanical strength. As an example of resin-conjugated o-naphthoquinonediazido compounds, o-naphthoquinonediazidosulfonic esters of a polycondensed resin of pyrogallol and acetone are disclosed in JP-B-68/28403. A photosensitive layer using such esters has a relatively good performance, but when ordinary novolak resins such as an m-cresol novolak resin are used as a binder for the esters, the photosensitive layer proves to have unsatisfactory printing durability, particularly when UV ink is used for printing.

In order to improve further the printing durability, chemical resistance and other properties mentioned above, there have been proposed photosensitive compositions containing various photosensitive materials and binders.

The photosensitive composition disclosed in JP-A-80/76346 contains a photosensive resin obtained by condensing a polyhydroxyphenyl compound prepared from a co-condensation polymerization of resorcinol or a derivative thereof, pyrogallol and acetone and an o-quinonediazido compound having a halogenosulfonyl group, and an alkali-soluble resin such as a phenol-formaldehyde resin as a binder. The photosensitive composition disclosed in JP-B-81/54621 contains an o-quinonediazido compound as a photosensitive material and a resin obtained by co-condensing phenol, mixed m- and p-cresol and aldehyde as a binder. Since a novolak resin is still used as a binder in these photosensitive compositions, the photosensitive layer has low film strength at the image area and has poor printing durability.

To improve the printing durability, a so-called burning treatment is generally employed in which the photosensitive layer is subjected to high-temperature heating after exposure and development. This burning treatment, however, has the problem that, at the time of heating, the monomer component of the resin might run out of the photosensitive layer at the image area and deposit on the non-image area causing scumming at the time of printing.

The photosensitive composition disclosed in JP-B-77/28401 contains a photosensitive material composed of an o-naphthoquinone-diazidosulfonic acid derivative and a binder composed of an acrylic high-molecular weight compound having structural units of formula:

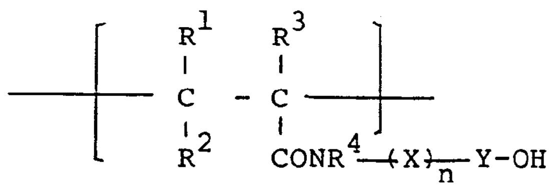

wherein $R^1$ and $R^2$ each represent a hydrogen atom or an alkyl or carboxyl group, $R^3$ represents a hydrogen atom, a halogen atom or an alkyl group, $R^4$ represents a hydrogen atom or an alkyl, phenyl or aralkyl group, X represents a divalent organic group connecting the nitrogen atom and the aromatic ring carbon atom in Y, n is 0 or 1, and Y represents an optionally substituted phenylene or naphthylene group. Since a polymeric compound having this structural unit is used instead of a novolak resin as a binder in this photosensitive composition, the photosensitive layer formed therefrom has high film strength and good printing durability.

US-A-4,009,033 discloses a photoresist comprising a resin, a quinone-diazide type sensitizer (e.g. the 4′,2′,3′-dihydroxybenzophenone ester of 1-oxo-2-diazonaphthalene-5-sulphonic acid) and an organic acidic

compound.

IBM Technical Disclosure Bulletin 25, 3A, August 1982 discloses the addition of polyethers or polyether alcohols at 0.5 to 2% by weight to resists.

Other prior art techniques may be found in EP-A-0179948 which discloses a photosensitive planographic printing plate comprising an aluminium or aluminium alloy plate having an anodic oxidation layer obtained by anode oxidation in an electrolyte of phosphoric acid or in an electrolyte of mixed acids but containing the phosphoric acid as a main component, and a layer of photopolymerizable photosensitive composition overlaid on the Al or Al alloy plate and containing a polymer binder having a carboxylic acid residue or carboxylic acid anhydride residue, an addition polymerizable unsaturated compound and a photo-polymerization initiator; and EP-A-0177962 which discloses a photosensitive composition comprising: (a) a photosensitive diazo resin of formula (A):

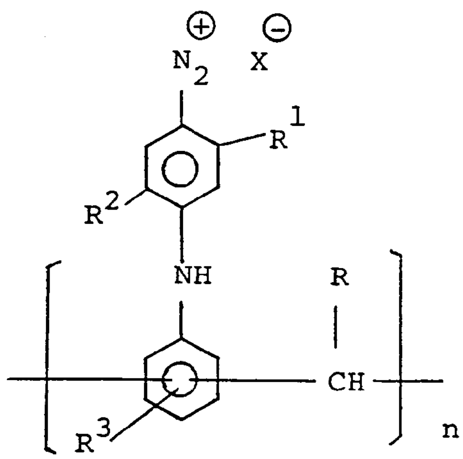

(A)

wherein $R^1$, $R^2$ and $R^3$ each represents a hydrogen atom, an alkyl or alkoxy group, R represents a hydrogen atom, an alkyl or phenyl group, X represents $PF_6$ or $BF_4$ and n represents a number of from 1 to 200, in which a resin with the number n in the above formula being 5 or more is present is an amount of more than 20 mol%, (b) an oleophilic high molecular weight compound having a hydroxyl group, and (c) a high molecular weight organic acid not having a hydroxyl group, and in which the content of (c) is from 1.5 to 30% by weight based on the solid matter in said composition. This photosensitive composition provides a photosensitive layer having high sensitivity, excellent storage stability and developability and excellent film strength.

The positive photosensitive planographic printing plate having a photosensitive layer composed of the photosensitive composition of JP-A-77/28401 has relatively high printing durability and chemical resistance in an ordinary style of printing, but is still unsatisfactory for UV printing. This printing plate also has a narrow development latitude. "UV printing" herein refers to printing carried out using an ink containing an ultraviolet absorber (UV ink). The unsuitability of the printing plate for UV printing is due to the low chemical resistance or high susceptibility of the photosensitive layer to the ink and chemicals used in UV printing.

The present invention provides a positive photosensitive planographic printing plate comprising, on a support, a photosensitive layer comprising:

(A) the o-naphthoquinonediazidosulfonic ester of a polyhydroxybenzophenone, or derivative thereof; and

(B) a high-molecular weight compound comprising structural units of formula (I):

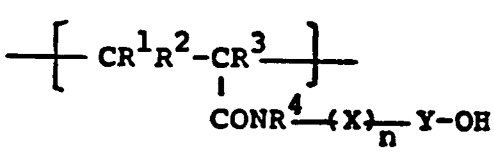

(I)

wherein:

$R^1$ and $R^2$ are each, independently, hydrogen, a halogen or an alkyl, aryl or carboxyl group;

$R^3$ is hydrogen, a halogen or an alkyl or aryl group;

$R^4$ is hydrogen, or an alkyl, aryl or aralkyl group;

Y is an optionally substituted aromatic group, a carbon atom of which is attached to X if n is not 0;

X is a divalent organic group; and

n is an integer of from 0 to 5; or
a high molecular weight compound of formula:

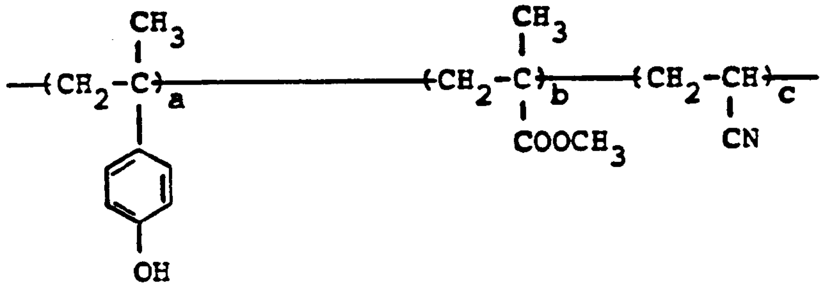

wherein a:b:c: = 20:40:40, Mw is 54,000 and Mw/Mn is 8.2; and
(C) a compound comprising from 2 to 5,000 units of at least one of the units of formulae (II) and (III) and/or an organic acid having a pKa of at least 2:

$$-(CH_2CH_2O)- \quad (II)$$

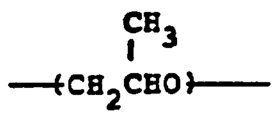

(III)

The photosensitive composition used in the printing plate of the present invention is well appliable to UV printing, has improved development latitude and excellent ballpen performance.

The "ballpen performance" referred to in this specification is defined as follows: when printing original films on a photosensitive planographic printing plate successively by changing the printing position (so-called multiple printing), it may be necessary to mark the film positions on the photosensitive layer for correct positioning of the original films. Usually an oleaginous ballpen is used as marking means. In this case, if the solvent of the ballpen ink is an organic solvent, especially a high-boiling point solvent such as glycols, the photosensitive layer may be corroded and dissolved by the ink. In case the marked position coincides with the image area, the photosensitive layer at the marked part of the image area may be removed in the course of development and the marks might inconveniently be reproduced on the prints. Resistance against corrosion by the ballpen ink is called "ballpen performance", and a photosensitive composition having a good ballpen performance is desired.

The printing plate of the present invention has extremely high chemical resistance, is well appliable to UV ink printing with no need of burning treatment and also has excellent printing durability. The printing plate also has high sensitivity and broad development latitude.

The printing plate of the present invention additionally has excellent ballpen performance.

The use of specific low-molecular weight derivatives of an o-naphthoquinonediazidosulfonic acid, more specifically an o-naphthoquinonediazidosulfonic ester of a polyhydroxybenzophenone, or derivative thereof, as photosensitive material surprisingly provides a positive photosensitive planographic printing plate having excellent chemical resistance and printing durability in UV printing, great development latitude and splendid ballpen performance.

In the polyhydroxybenzophenones, used in this invention in the form of their o-naphthoquinonediazidosulfonic esters (A) or derivatives thereof, at least two hydrogen atoms of benzophenone are substituted with hydroxyl groups. Examples are dihydroxybenzophenones, trihydroxybenzophenones, tetrahydroxybenzophenones, pentahydroxybenzophenones and octahydroxybenzophenones; examples of the derivatives are those in which the phenyl nucleus is substituted with halogen atom(s), alkyl group(s), aryl group(s), aralkyl group(s) and carboxyl group(s). Among these compounds, trihydroxybenzophenones and tetrahydroxybenzophenones are preferred. 2,3,4-trihydroxybenzophenone and 2,3,4,4′-tetrahydroxybenzophenone are most preferred.

Examples of the o-naphthoquinonediazidosulfonic acids are 1,2-naphthoquinone-2-diazido-5-sulfonic acid, 1,2-naphthoquinone-2-diazido-4-sulfonic acid and 1,2-naphthoquinone-2-diazido-6-sulfonic acid.

The o-naphthoquinonediazidosulfonic esters of polyhydroxybenzophenones can be synthesized by conventional methods. Usually a polyhydroxybenzophenone and the acid chloride of an o-naphthoquinonediazidosulfonic acid are reacted in the presence of a catalyst such as an alkali carbonate or triethylamine.

The substantial condensation rate in the esters (the amount of o-naphthoquinonediazidosulfonic acid

bonded to one hydroxyl group of polyhydroxybenzophenone) is preferably from 30 to 100%, more preferably from 40 to 99%, even more preferably from 50 to 98%. When the substantial condensation rate is too low, the composition has lowered ballpen performance. When the condensation rate is too high, the synthesis of the esters is very difficult.

The amount of component (A) in the composition constituting the photosensitive layer is preferably from 5 to 50% by weight, more preferably from 10 to 40% by weight. When the amount of (A) is below this range, the composition has lowered ballpen performance. When it is above this range, the composition has lowered sensitivity.

In the present invention it is of course possible to add where necessary other esters than those of polyhydroxybenzophenones as photosensitive material within limits not prejudicial to the intended effect of the invention. For example, known esters such as esterified products of a pyrogallol-acetone resin, resorcin-benzaldehyde resin, and cresol resin, having a molecular weight of about 500 to 5,000 can be contained in an amount below 50% by weight in the photosensitive composition.

The high-molecular weight compounds used as component (B) of the photosensitive layer may be either homopolymers or copolymers having one or more monomer units besides the structural units of formula (I).

In formula (I) $R^1$ and $R^2$ are each preferably hydrogen, an alkyl group such as methyl or ethyl, or a carboxyl group. More preferably both of them are hydrogen atoms. $R^3$ is preferably hydrogen, a halogen such as bromine or chlorine, or an alkyl group such as methyl or ethyl. More preferably $R^3$ is hydrogen or a methyl group. $R^4$ is preferably hydrogen or an alkyl group such as methyl or ethyl, hydrogen being most preferred. Y is preferably an optionally substituted phenylene or naphthylene group.

Examples of substituents are an alkyl group such as methyl or ethyl, a halogen such as bromine or chlorine, a carboxyl group, an alkoxyl group such as methoxy or ethoxy, a hydroxyl group, a sulfonic acid group, a cyano group, a nitro group and an acyl group. More preferably Y is a phenylene or naphthylene group which is unsubstituted or substituted with methyl group(s). X is a divalent organic group linking the nitrogen atom and a carbon atom of the aromatic group, and is preferably an alkylene group. n is preferably from 0 to 3, more preferably 0.

In the high-molecular weight compounds having a copolymer structure, the monomer units usable in combination with the structural units of formula (I) may be vinyl monomers of various types, for example, ethylenic unsaturated olefins such as ethylene, propylene, isobutylene, butadiene and isoprene; styrenes such as styrene, α-methylstyrene, p-methylstyrene and p-chlorostyrene; acrylic acids such as acrylic acid and methacrylic acid; unsaturated aliphatic dicarboxylic acids such as itaconic acid, maleic acid and maleic anhydride; α-methylene aliphatic monocarboxylic acid esters such as methyl acrylate, ethyl acrylate, n-butyl acrylate, isobutyl acrylate, dodecyl acrylate, 2-chloroethyl acrylate, phenyl acrylate, methyl α-chloroacrylate, methyl methacrylate and ethyl methacrylate; nitriles such as acrylonitrile and methacrylonitrile; amides such as acrylamide; anilides such as acrylanilide, p-chloroacrylanilide, m-nitroacrylanilide and m-methoxyacrylanilide; vinyl esters such as vinyl acetate, vinyl propionate, vinyl benzoate and vinyl butyrate; vinyl ethers such as methyl vinyl ether, ethyl vinyl ether, isobutyl vinyl ether and β-chloroethyl vinyl ether; vinyl chloride, vinylidene chloride, vinylidene cyanide, and ethylene derivatives such as 1-methyl-1′-methoxyethylene, 1,1′-dimethoxyethylene, 1,2-dimethoxyethylene, 1,1′-dimethoxycarbonylethylene and 1-methyl-1′-nitroethylene; N-vinyl compounds such as N-vinylpyrrole, N-vinylcarbazole, N-vinylindole, monomers exist in the high-molecular weight compounds in a structural form involving unsaturated double bond cleavage.

Among said monomers, methacrylic acids, acrylic acids, aliphatic monocarboxylic acid esters and nitriles are preferred as these monomers generally have excellent performance. Methacrylic acid, methyl methacrylate, acrylonitrile and ethyl acrylate prove most effective.

These monomers may be bonded blockwise or randomly in the high-molecular weight compounds.

Typical examples of the high-molecular compounds (B) are shown below wherein Mw is the weight-average molecular weight, Mn is the number-average molecular weight, and a, b, c, d and e the mol% of the units.

$$\text{(a)}\; -\!\!\!-\!\!\left(\text{formula (I)}\right)_a\!-\!\!\left(CH_2-\underset{COOR^2}{\underset{\backslash}{CR^1}}\right)_b\!-\!\!\!-$$

($R^1$ and $R^2$ = hydrogen, alkyl or halogen; a = 10 to 60 mol%, b = 40 to 90 mol%)

(b) 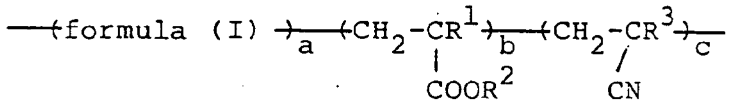

($R^1$-$R^3$) = hydrogen, alkyl or halogen; a = 10 to 60 mol%, b = 10 to 60 mol%, c = 10 to 60 mol%)

(c) 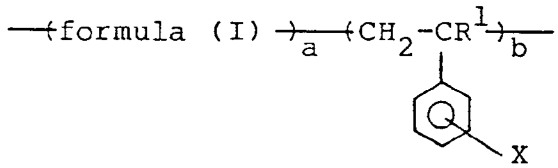

(X = alkyl or halogen; $R^1$ = hydrogen, alkyl or halogen; a = 10 to 60 mol%, b = 40 to 90 mol%)

(d) 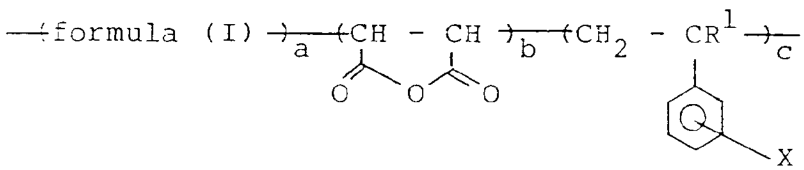

(X = alkyl or halogen; $R^1$ = hydrogen, alkyl or halogen; a = 10 to 60 mol%, b = 10 to 60 mol%, c = 10 to 60 mol%)

(e) 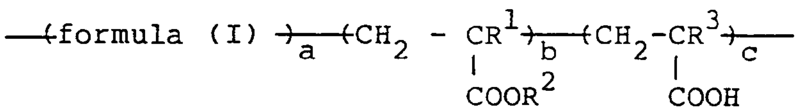

($R^1$ - $R^3$ = hydrogen, alkyl or halogen; a = 10 to 60 mol%, b = 10 to 60 mol%, c = 20 mol% or less)

(f) 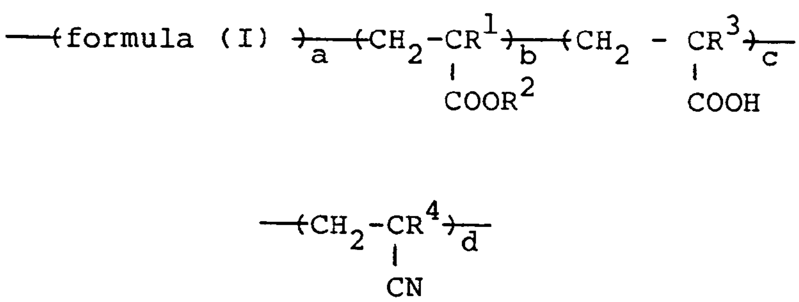

($R^1$ - $R^4$ = hydrogen, alkyl or halogen; a = 10 to 60 mol%, b = 10 to 60 mol%, c = 0 to 20 mol%, d = 10 to 60 mol%)

(g) 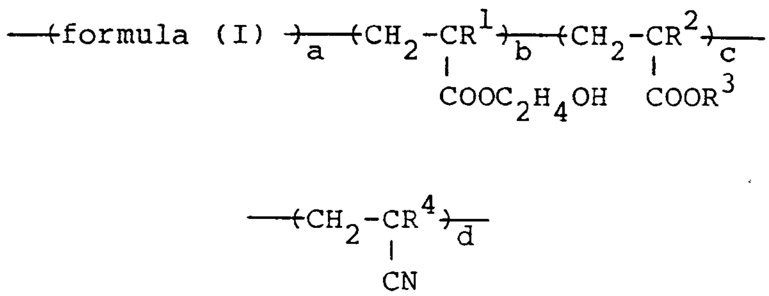

($R^1$ - $R^4$ = hydrogen, alkyl or halogen; a = 10 to 60 mol%, b = 10 to 60 mol%, c = 10 to 60 mol%, d = 10 to 60 mol%)

(h) 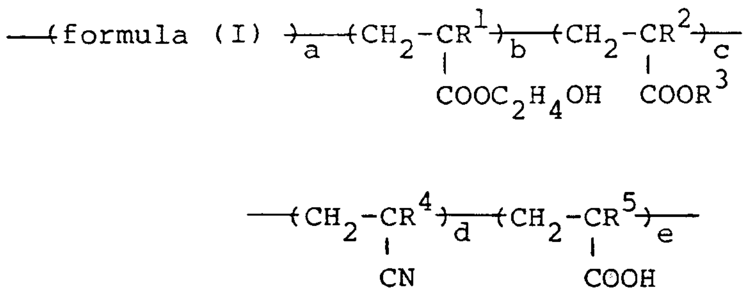

($R^1$ - $R^5$ = hydrogen, alkyl or halogen; a = 10 to 60 mol%, b = 10 to 60 mol%, c = 10 to 60 mol%, d = 10 to 60 mol%, e = 20 mol% or less).

Among the compounds of the formulae (a) - (h) those of the formulae (a), (b), (e), (f) and (g) are especially preferred.

Shown below are more specific examples of the compounds:

(a - 1) 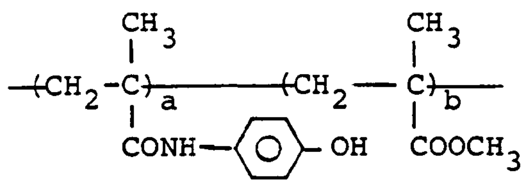

(Mw = 28000, Mw/Mn = 7.8, a:b = 40:60)

(a - 2) 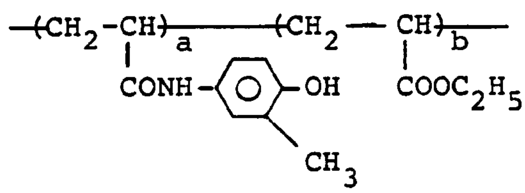

(Mw = 40000, Mw/Mn = 2.5, a:b = 50:50)

(b - 1) 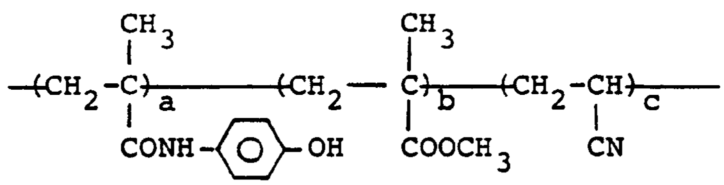

(Mw = 18000, Mw/Mn = 2.1, a:b:c = 30:40:30)

(b - 2) 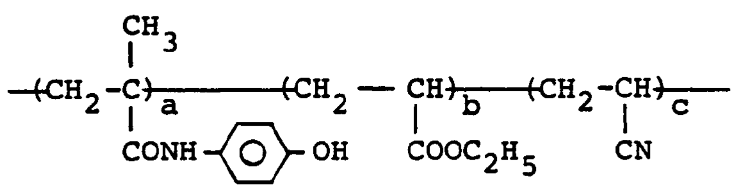

(Mw = 60000, Mw/Mn = 7.5, a:b:c = 40:20:40)

(b-3)

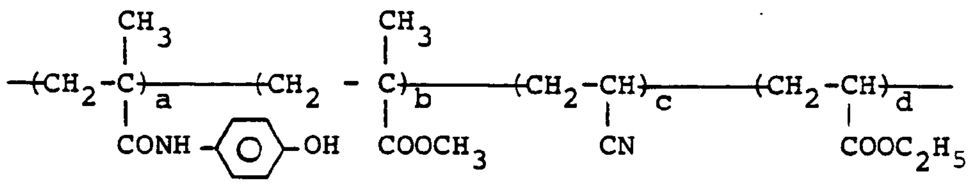

(Mw = 20000, Mw/Mn = 2.2, a:b:c:d = 30:34:30:4)

(c - 1)

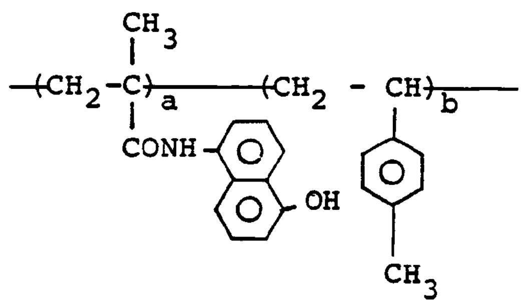

(Mw = 21000, Mw/Mn = 5.3, a:b = 50:50)

(c - 2)

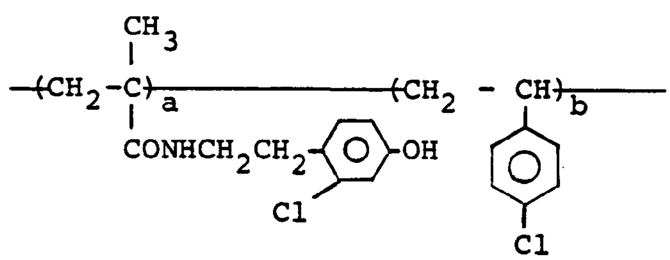

(Mw = 42000, Mw/Mn = 4.8, a:b = 30:70)

(d - 1)

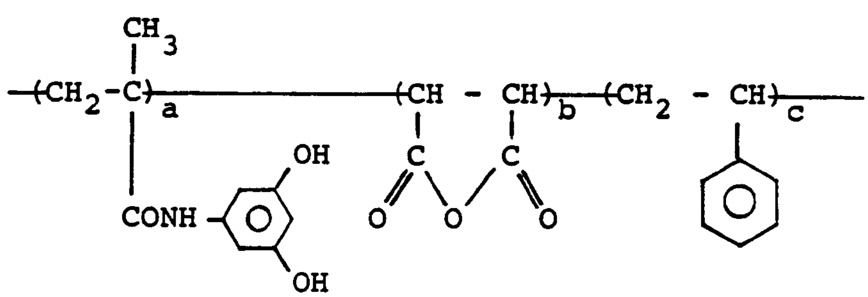

(Mw = 33000, Mw/Mn = 3.5, a:b:c = 30:35:35)

(d - 2)

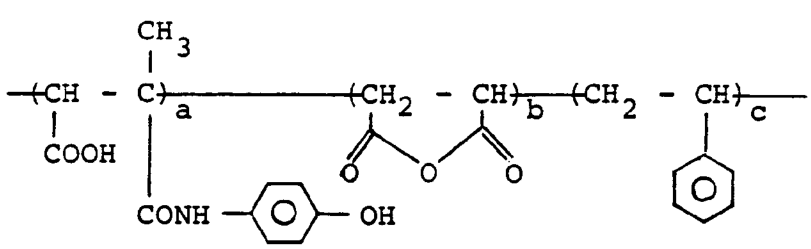

(Mw = 57000, Mw/Mn = 2.9, a:b:c = 25:25:50)

(e - 1) 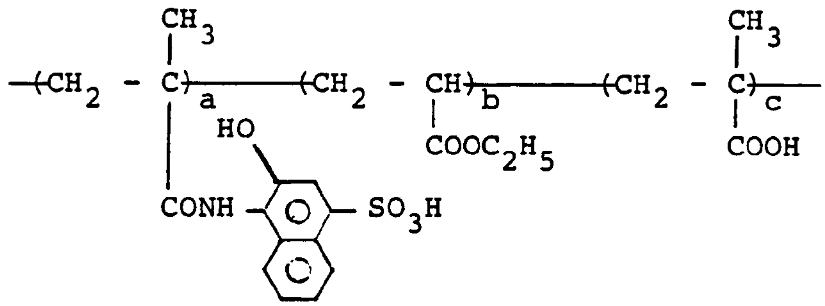

(Mw = 21000, Mw/Mn = 7.2, a:b:c = 50:45:5)

(e - 2) 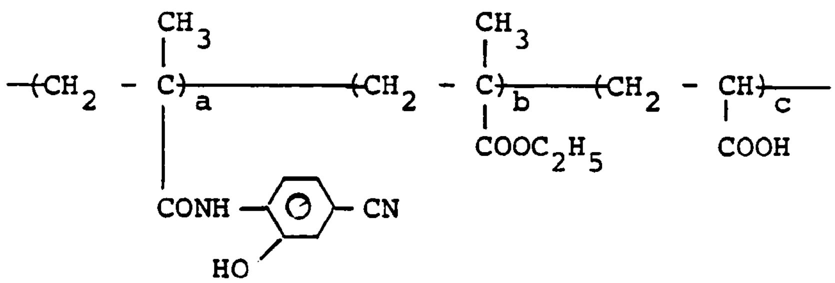

(Mw = 33000, Mw/Mn = 7.0, a:b:c = 38:60:2)

(f - 1) 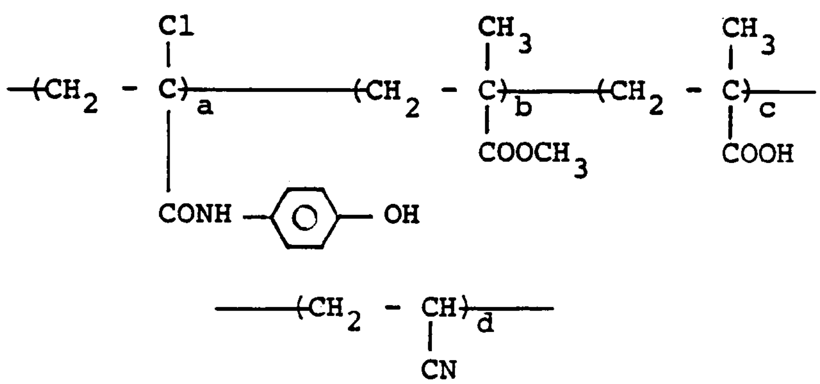

(Mw = 34000, Mw/Mn = 4.8, a:b:c:d = 20:30:5:45)

(f - 2) 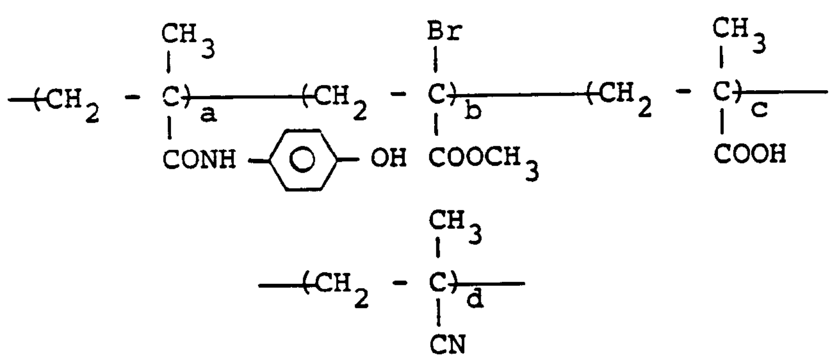

(Mw = 32000, Mw/Mn = 4.4, a:b:c:d = 20:35:5:40)

(g - 1) 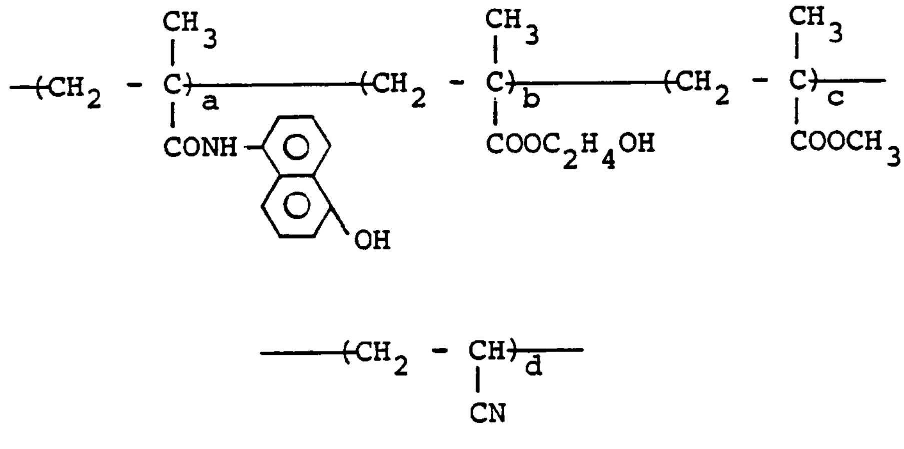

(Mw = 48000, Mw/Mn = 5.3, a:b:c:d = 30:10:30:30)

(h - 1) 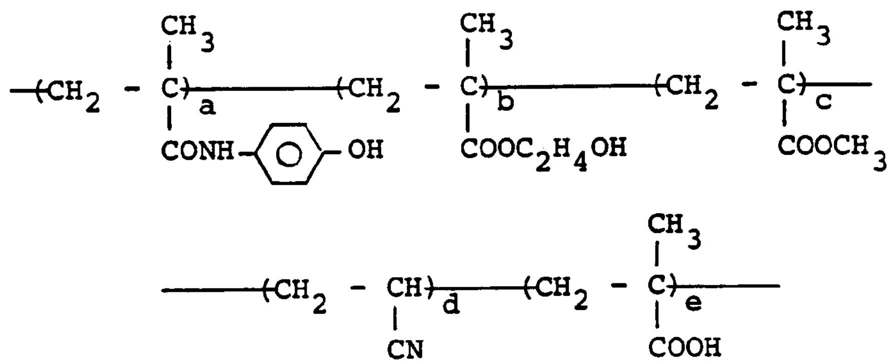

(Mw = 35000, Mw/Mn = 7.9, a:b:c:d:e = 20:15:30:33:2)

The high-molecular weight compounds (B) can be synthesized by conventional methods, e.g. in the following way. An α,β-insaturated acid chloride or α,β-unsaturated acid anhydride and a primary or secondary amine having phenolic hydroxyl group(s) are reacted using, if necessary, a basic catalyst to synthesize a monomer having the structural unit of formula (I). The monomer is then monopolymerized by a known method or the monomer and at least one other vinyl monomer are copolymerized. The high-molecular weight compounds (B) obtained may have a wide range of molecular weights and molar ratios of structural units by changing the molar ratios of the monomers used and the polymerization conditions. However, for the effective use of these compounds for the intended purpose of this invention, it is desirable that the compounds have a weight-average molecular weight of from 5,000 to 100,000, more preferably from 5,000 to 50,000. The content of the structural unit of formula (I) is preferably not less than 10 mol%, more preferably from 10 to 50 mol%.

Determination of molecular weight of the high-molecular weight compounds has been made by the gel permeation chromatography (GPC) method.

The amount of the compound (B) in the composition of the photosensitive layer is preferably from 50 to 95% by weight, more preferably from 60 to 90% by weight.

The composition of the photosensitive layer may contain known alkali-soluble high-molecular weight compound(s), for example, a novolak resin such as phenol-formaldehyde or cresol-formaldehyde resin, phenolic modified xylene resin and polyhydroxystyrene resin. The amount of such alkali-soluble high-molecular compound added should preferably not exceed 60% by weight of the total composition. If such an alkali-soluble high-molecular compound is contained in a greater amount, the image area becomes vulnerable to the action of a UV ink or plate cleaner in the photosensitive layer, making the use of a UV ink difficult.

Novolak resins are most preferred for use as alkali-soluble high-molecular compounds.

The novolak resins recommended for use in this invention are those resins obtainable by condensing phenol(s) and formaldehyde in the presence of an acid catalyst. Illustrative examples of the phenols are phenol, o-cresol, m-cresol, p-cresol, 3,5-xylenol, 2,4-xylenol, 2,5-xylenol, carvacrol, thymol, catechol, resorcin, hydroquinone, pyrogallol and phloroglucinol. These phenolic compounds may be used either singly or in combination

to obtain the desired resin. The preferred novolak resins are obtainable by co-condensation polymerization of at least of phenol, m-cresol (or o-cresol) and p-cresol with formaldehyde. Among such novolak resins there may be mentioned phenol-formaldehyde resin, m-cresol-formaldehyde resin, o-cresol-formaldehyde resin, phenol-p-cresol-formaldehyde copolymer resin, m-cresol-p-cresol-formaldehyde co-condensation polymer resin, o-cresol-p-cresol-formaldehyde co-condensation polymer resin, phenol-m-cresol-p-cresol-formaldehyde co-condensation polymer resin, and phenol-o-cresol-p-cresol-formaldehyde co-condensation polymer resin. Among these novolak resins, phenol-m-cresol-p-cresol-formaldehyde resin is most preferred.

The novolak resins may be used either singly or in combination.

The molecular weight (on polystyrene standard) of the novolak resins is preferably from 1.0 x $10^3$ to 3.0 x $10^4$, more preferably from 3.0 x $10^3$ to 2.0 x $10^4$ in terms of weight-average molecular weight and from 3.0 x $10^2$ to 7.5 x $10^3$, more preferably from 5.0 x $10^2$ to 4.0 x $10^3$ in terms of number-average molecular weight.

When the novolak resin is added, the amount thereof in the photosensitive layer is preferably from 0.01 to 50% by weight, more preferably from 1 to 14% by weight.

Component (C) is the photosensitive layer may be an organic acid having a pKa of at least 2. Use of such an organic acid increases the sensitivity of the photosensitive layer and raises the developing performance of the developer which has been reduced in sensitivity or developing capacity (such developing performance being hereinafter referred to as "underdevelopability"). It also improves the recovery from scumming on the non-image area (hereinafter referred to as "scumming-recovery on the press").

The organic acid preferably has a pKa of from 3.0 to 9.0, more preferably from 3.5 to 8.0. When the pKa is too small, the effect of the organic acid for improving underdevelopability and scumming-recovery on the press is unsatisfactory and there is little improvement of sensitivity. The pKa values mentioned here are measured at 25°C.

Typical examples of the organic acids are the monocarboxylic acids and dicarboxylic acids shown in the Handbook of Chemistry, Fundamentals II (pp. 1054-1058, 1966, Maruzen) which have a pKa in the range specified above. Such monocarboxylic acids and dicarboxylic acids include adipic acid, azelaic acid, isophthalic acid, β-ethyl-glutaric acid, benzoic acid, m-hydroxybenzoic acid, p-hydroxybenzoic acid, glyceric acid, glutaconic acid, glutaric acid, succinic acid, β,β-diethylglutaric acid, 1,1-cyclobutanedicarboxylic acid,
1,3-cyclobutanedicarboxylic acid,
1,3-cyclobutanedicarboxylic acid,
1,2-cyclopentanedicarboxylic acid,
1,3-cyclopentanedicarboxylicacid, β,β-dimethylglutaric acid, dimethylmalonic acid, α-tartaric acid, suberic acid, terephthalic acid, pimelic acid, phthalic acid, fumaric acid, β-propylglutaric acid, propylmalonic acid, mandelic acid, mesotartaric acid, β-methylglutaric acid, β,β-methylpropylglutaric acid, methylmalonic acid, malic acid,
1,1-cyclohexanedicarboxylic acid,
1,2-cyclohexanedicarboxylic acid,
1,3-cyclohexanedicarboxylic acid,
1,4-cyclohexanedicarboxylic acid and
1,2-cyclohexenedicarboxylic acid. Other organic acids having an enol structure such as merdrum acid and ascorbic acid can also be favorably used.

The amount of the organic acid in the photosensitive layer is preferably from 0.05 to 10% by weight, more preferably from 0.1 to 10% by weight, of the total composition.

Component (C) may also, or additionally, be a compound comprising at least one of the following structural units:

$$-(CH_2CH_2O)- \qquad (II)$$

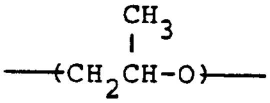

(III)

Addition of such compound(s) improves tolerance against white fluorescent light exposure (hereinafter referred to as "safe-light tolerance") as well as ink adhesion to the plate surface at the start of printing (hereinafter referred to as "ink adhesiveness").

Any compound having at least one of the above structural units (II) and (III) is usable in this invention, but it is recommended to use those compounds which comprise from 2 to 5,000 units of at least one of the units of formulae (II) and (III), more preferably from 2 to 500, most preferably from 3 to 100. When amounts of these units are used which are outside the above-defined range, the composition constituting the photosensitive layer has lowered developability.

Examples of such compounds are polyethylene glycol $HO{-}(CH_2CH_2O){-}_m H$; polyoxyethylene alkyl ether $RO(CH_2CH_2O)_mH$; polyoxyethylene alkylphenyl ether

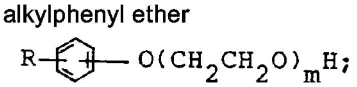

polyoxyethylene polystyrylphenyl ether

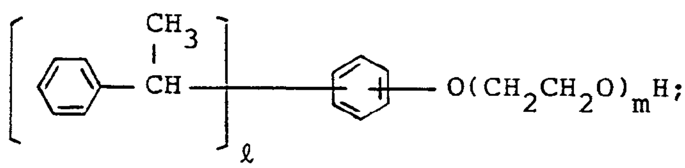

polyoxyethylene-polyoxypropylene glycol

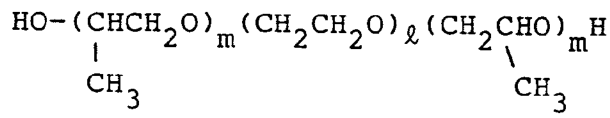

(including both block polymers and random polymers); polyoxyethylene-polyoxypropylene alkyl ether (forming alkyl ether at the end of the molecule; including random polymers);

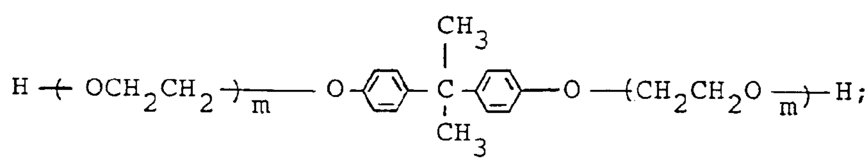

ethylene oxide derivatives of alkylphenol-formaldehyde condensate

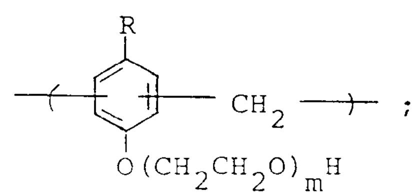

polyoxyethylene-polyhydric alcohol fatty acid partial esters such as

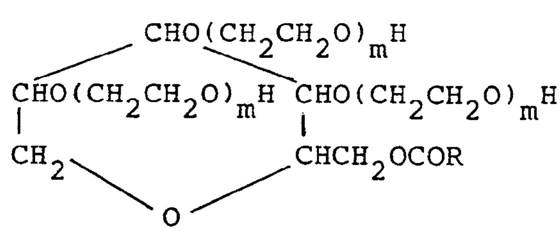

and

$$CH_2O(CH_2CH_2O)_mOCR$$
$$CHO(CH_2CH_2O)_mOCR$$
$$CHO(CH_2CH_2O)_mH$$
$$CHO(CH_2CH_2O)_mH$$
$$CHO(CH_2CH_2O)_mH$$
$$CH_2O(CH_2CH_2O)_mH;$$

polyoxyethylene fatty acid esters such as $RCOO(CH_2CH_2O)_mH$; polyoxyethylene alkyl amines

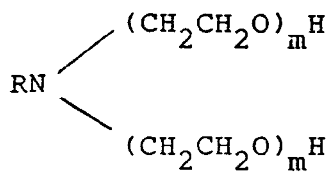

;

polyoxyethylene castor oil; and polyoxyethylene sorbitol fatty acid esters

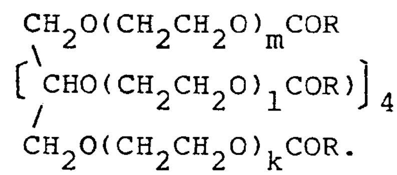

The following are preferred examples: polyoxyethylene lauryl ether, polyoxyethylene cetyl ether, polyoxyethylene stearyl ether, polyoxyethylene oleyl ether, polyoxyethylene higher alcohol ether, polyoxyethylene octylphenyl ether, polyoxyethylene nonylphenyl ether, polyoxyethylene sorbitan monolaurate, polyoxyethylene sorbitan monopalmitate, polyoxyethylene sorbitan monostearate, polyoxyethylene sorbitan tristearate, polyoxyethylene sorbitan monooleate, polyoxyethylene sorbitan trioleate, polyoxyethylene sorbitol tetraoleate, polyethylene glycol monolaurate, polyethylene glycol monostearate, polyethylene glycol monooleate, polyethylene glycol distearate, polyoxyethylene nonylphenyl ether-formaldehyde condensate, oxyethylene-oxypropylene block copolymer, polyethylene glycol, tetraethylene glycol, polyoxyethylene stearyl ether, polyoxyethylene sorbitol lauryl ester, and polyoxyethylene castor oil.

The amount of such compound(s) in the photosensitive layer is preferably from 0.1 to 20% by weight, more preferably from 0.2 to 10%, by weight based on the total composition.

These compounds may be used either singly or in combination provided that the content thereof in the composition is within the above range.

Generally, the positive type photosensitive planographic printing plates also contain an image-additive after exposure and a pigment. Usually a material which generates an acid upon exposure is used as an image-additive after exposure, and a compound which forms a salt with said acid is used as a pigment.

As the material which generates an acid upon exposure, trihaloalkyl compounds or diazonium salt compounds of formulae (IV) or (V) are preferably used:

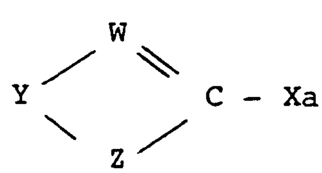

(IV)

wherein Xa is a trihaloalkyl group having from 1 to 3 carbon atoms, W is N or P, Z is O, S or Se, and Y is a group which, together with W and Z, forms a ring and has a chromophoric group, and

$$Ar - N^{+}_{2}X^{-} \quad (V)$$

wherein Ar is an aryl group and X is an inorganic counter ion.

As more concrete examples of the trihaloalkyl compounds of formula (IV), compounds of formulae (IVa), (IVb) and (IVc) may be mentioned:

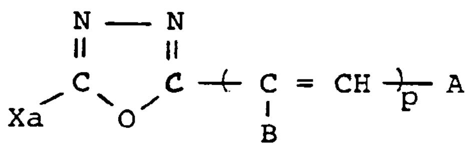
(IVa)

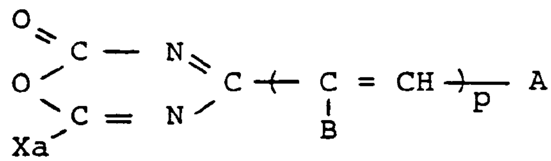
(IVb)

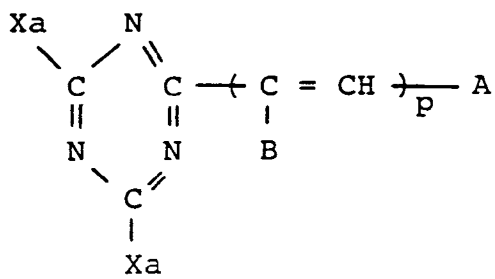
(IVc)

wherein A is a substituted or unsubstituted aryl group or a heterocyclic group, B is hydrogen or a methyl group, and p is an integer of from 0 to 2.

The amount of the image-additive after exposure added is preferably from 0.01 to 20% by weight, more preferably from 0.1 to 10% by weight, based on the total composition of the photosensitive layer.

Any compound capable of forming a salt with the acid is usable as a pigment; typical examples are triphenylmethane dyes, cyanine dyes, diazo dyes and styryl dyes.

More concretely, such dyes include Victoria pure blue BOH, ethyl violet, crystal violet, brilliant green, basic fuchsine, eosine, phenolphthalein, xylenol blue, Congo red, malachite green, oil blue #603, oil pink #312, cresol red, auramine, 4-p-diethylaminophenyl-iminonaphthoquinone, leucomalachite green, and leuco-crystal violet. The amount of pigment used is preferably from 0.01 to 10% by weight, more preferably from 0.05 to 8% by weight, based on the total composition of the photosensitive layer.

The photosensitive layer composition of the positive photosensitive planographic printing plate according to this invention may contain various other additives, depending upon the intended purpose. For instance, a surface active agent may be added to improve spreadability, various sensitizers to improve sensitivity and a plasticizer to improve the coating film properties. Also, for increasing printing ink adhesiveness to the image area, there can be added various additives having a hydrophobic group, such as a
p-octylphenol-formalin novolak resin,
p-t-butylphenol-formalin novolak resin,
p-t-butylphenol-benzaldehyde resin, modified novolak resin such as rosin-modified novolak resin, and
o-naphthoquinonediazidosulfonic ester of such modified novolak resins (the esterification amount of hydroxyl groups being 20 to 70%). The content of these additives depends on the type of the additives(s) used and the purpose, but generally these additives are contained in an amount of from 0.01 to 20% by weight, preferably from 0.05 to 10% by weight, based on the total composition of the photosensitive layer.

The photosensitive layer composition is dissolved in a suitable solvent, for example cellosolves such as methyl (ethyl) cellosolve, and methyl (ethyl) cellosolve acetate, or other coating solvents such as dimethylformamide, dimethyl sulfoxide, dioxane, acetone, cyclohexane, and trichloroethylene, then coated on a support and dried to form a photosensitive layer.

The photosensitive layer of the positive photosensitive planographic printing plate according to this invention is preferably so formed that its weight per unit area calculated in terms of solids is from 0.5 to 3.0 $g/m^2$ although subject to change according to the purpose of use of the printing plate. Coating of the photosensitive layer on the support surface can be accomplished by various known methods such as rotational coating, wire bar coating, dip coating, air knife coating, roll coating, blade coating and curtain coating.

As the support used for the positive photosensitive planographic printing plate of this invention, the following may be mentioned: metal plates such as aluminium, zinc, steel and copper plates; metal plates plated or vapor-deposited with, for example, chromium, zinc, copper, nickel, aluminium or iron; paper; plastic films and glass plates; resin-coated paper; paper foiled with a metal such as aluminium; and plastic films subjected to a hydrophilic treatment. Among them an aluminium plate is preferred. The aluminium plate is preferably subjected to sand graining, anodizing and, if necessary, a surface treatment such as sealing. These treatments can be performed by known methods.

Sand graining can be accomplished either by mechanical methods or by electrolytic etching. The mechanical methods include ball polishing, brushing, liquid honing and buffing. These methods may be used either singly or in combination according to the aluminium plate composition and other factors. Usually electrolytic etching is preferred.

Electrolytic etching is carried out by immersing an aluminium plate in a bath containing one or more inorganic acids such as phosphoric acid, sulfuric acid, hydrochloric acid and nitric acid. After sand graining, the plate is subjected if necessary to a desmutting treatment with an alkali or an acid, neutralized and then washed with water.

Anodizing treatment is performed by carrying out electrolysis on the aluminium plate serving as anode in an electrolytic solution containing at least one of sulfuric acid, chromic acid, oxalic acid, phosphoric acid, malonic acid and other like acids. The amount of the oxide film thus formed is preferably from 1 to 50 $mg/dm^2$, more preferably from 10 to 40 $mg/dm^2$. The amount of the formed oxide film can be determined, for example, by immersing the anodized aluminium plate in a phosphoric acid-chromic acid solution (formed by dissolving 35 ml of aqueous 85% phosphoric acid solution and 20 g of chromium oxide (VI) in 1 litre of water) to dissolve the oxide film and measuring the weight change of the plate before and after dissolution of the oxide film.

Sealing of the aluminium plate surface can be accomplished, for example, by boiling water treatment, water vapor treatment, sodium silicate treatment or bichromate solution treatment. The aluminium support may be also subjected to a substratum treatment with an aqueous solution of a water-soluble high-molecular weight compound or a metal salt such as fluorozirconate.

The positive photosensitive planographic printing plate obtained in the manner described above can be put to practical use in known ways. Typically, a positive film is tightly adhered to the photosensitive printing plate, exposed to, for example, an ultra-high pressure mercury lamp or metal halide lamp as a light source and developed with an alkaline aqueous solution such as an aqueous solution of, for example, sodium metasilicate, potasium metasilicate, sodium phosphate or sodium hydroxide to obtain the desired printing plate.

The thus obtained planographic printing plate of this invention is usable in sheet-fed presses and roll-fed offset printing presses.

## Examples

The present invention is now further described in detail below. In the description which follows, all the "parts" are by weight unless otherwise noted.

First, synthesis of the high-molecular weight compounds and photosensitive materials (o-quinonediazidosulfonic esters) used in this invention is described.

(Synthesis of high-molecular weight compounds)

### SYNTHESIS EXAMPLE 1

### Synthesis of high-molecular weight compound (b-1)

A mixture of 400 g of p-hydroxyaniline, 4 g of hydroquinone monomethyl ether, 4 liters of acetone and 360 g of pyridine was cooled externally with a freezing medium, and at a point when the internal temperature of the mixture had been lowered to -10°C, 420 g of methacrylic acid chloride was added dropwise to the mixture with stirring. The dropping rate was adjusted so that the reaction temperature was kept below 0°C. After completion of the addition, the solution was stirred at 0 to 3°C for about 2 hours, followed by further stirring at 25°C for 2 hours. The reaction solution was concentrated to one-third of its original volume and poured into 10 liters of dilute hydrochloric acid (having a pH of about 1.0). The precipitate produced was filtered with suction to obtain white solids. These white solids were dissolved in 2 liters of heated methanol. To this solution was added

2 liters of 5% sodium carbonate solution, followed by stirring at 40°C for 30 minutes. This dark red solution was poured into 8 liters of 5% hydrochloric acid to form a large amount of precipitate. This precipitate was subjected to suction filtration and dried to obtain light-pink solids. The solids were recrystallized from an ethanol/water mixed solvent to obtain 450 g of colorless needle crystals of p-hydroxy-methacrylanilide having a melting point of 155 to 156°C.

53.2 g of the p-hydroxymethacrylanilide (HyPMA), 15.9 g of acrylonitrile (AN), 40.0 g of methyl methacrylate (MMA) and 3 g of $\alpha,\alpha'$-azobisisobutylonitrile were dissolved in 250 ml of ethanol. After atmospheric replacement with nitrogen gas, the solution was heated at 75°C for 4 hours to obtain a polymer solution. This polymer solution was poured into 3 liters of aqueous 5% HCl solution, and the white precipitate produced was filtered and dried to obtain 70 g of a white polymer. The molecular weight of the polymer was measured by the GPC method (Hitachi 635-Type, Column comprising Shodex A-804, A-803 and A-802 in series) using polystyrene as a standard. The Mn and Mw were calculated by the method described in the April 1972 issue of Bulletin of Japan Chemical Society, p. 800 (Tsuge, et al), in which the mean values are determined by levelling the peaks in the oligomer region (connecting the centers of the peak top and the bottom). The Mn of the polymer was 8,600 and the Mw was 18,000.

SYNTHESIS EXAMPLE 2

Synthesis of high-molecular weight compound (b-3)

53.1 g of the p-hydroxymethacrylanilide (HyPMA) obtained in Synthesis Example 1, 15.9 g of acrylonitrile (AN), 4 g of ethyl acrylate (EA), 36 g of methyl methacrylate (MMA) and 3 g of $\alpha,\alpha'$-azobisisobutylonitrile were dissolved in 150 ml of ethanol. After atmospheric replacement with nitrogen gas, the solution was heated at 75°C for 4 hours to obtain a polymer solution. This polymer solution was poured into 3 liters of aqueous 5% HCl solution. The white precipitate which formed was filtered and dried to obtain 65 g of a white polymer. The molecular weight of the polymer determined by the GPC method was 9,090 (Mn) and 20,000 (Mw).

SYNTHESIS EXAMPLE 3

Synthesis of high-molecular weight compound (e-2)

400 g of m-hydroxy-p-cyanoaniline, 4 g of hydroquinone monomethyl ether, 4 liters of acetone, and 360 g of pyridine were mixed and the mixture was cooled externally with a freezing medium. At a point when the internal temperature of the solution had dropped to -10°C, 420 g of methacrylic acid chloride was added dropwise to the mixture with stirring. Thereafter the mixture was treated in the same way as in Synthesis Example 1 to obtain 350 g of m-hydroxy-p-cyanomethacrylanilide.

76.8 g (0.38 mol) of the m-hydroxy-p-cyanomethacrylanilide was dissolved together with 68.4 g (0.60 mol) of ethyl methacrylate, 1.44 g (0.02 mol) of acrylic acid and 0.7 g of $\alpha,\alpha'$-azobisisobutylonitrile in 300 ml of an acetone/ethanol (1/2) mixed solvent. After replacing the atmosphere with nitrogen gas, the solution was heated at 65°C for 4 hours to obtain a polymer solution. This polymer solution was poured into 3 liters of aqueous 5% HCl solution and the white precipitate produced was filtered and dried, giving 75 g of a white polymer. Determination of molecular weight of this polymer by the GPC method showed Mn = 4,700 and Mw = 33,000.

SYNTHESIS EXAMPLE 4

Synthesis of high-molecular weight compound (g-1)

227 g of 5-amino-$\alpha$-naphthol, 1 g of hydroquinone monomethyl ether and 2 liters of pyridine were mixed and cooled to -10°C using a freezing medium, and then 110 g of methacrylic acid chloride was added dropwise to the mixture with stirring. After the addition had ended, the solution was stirred at 0 to 3°C for 2 hours, followed by an additional 2 hour stirring at 25°C. The reaction solution was poured into 20 liters of ice water. The precipitate which formed was filtered, washed with water and dried. The resulting solids were added into 2 liters of a methanol aqueous 5% sodium carbonate (1/1) mixed solvent, stirred at 40°C for 30 minutes and the solution was poured into 4 liters of 5% hydrochloric acid. A large amount of precipitate was formed. This precipitate was suction filtered and recrystallized from ethanol to give 210 g of N-(5-hydroxy-$\alpha$-naphthyl)methacrylamide having a melting point of 223 to 224°C.

68 g (0.3 mol) of the N-(5-hydroxy-$\alpha$-naphthyl)methacrylamide was dissolved with 10 g (0.1 mol) of 2-hydroxyethyl methacrylate, 30 g (0.3 mol) of methyl methacrylate, 15.9 g (0.3 mol) of acrylonitrile and 0.50 g of

α,α'-azobisisobutylonitrile in 200 ml of an acetone/ethanol (1/2) mixed solvent. The resulting solution was heated at 65°C for 8 hours in a closed tube having its inside atmosphere replaced with nitrogen gas. The treatment gave a copolymer solution. This copolymer solution was diluted with 100 ml of methanol and poured into water. The produced precipitate was filtered and dried to obtain 70 g of a white polymer. Determination of its molecular weight by the GPC method showed Mn = 9,100 and Mw = 48,000.

COMPARATIVE SYNTHESIS EXAMPLE 1

The process of Synthesis Example 1 was followed but using 2-hydroxyethyl methacrylate in place of p-hydroxymethacrylanilide. The molecular weight of the obtained polymer determined by the GPC method showed Mn = 2,300 and Mw = 15,000.

COMPARATIVE SYNTHESIS EXAMPLE 2

90 g of m-cresol, 56 g of p-cresol, 54 g of phenol, 105 g of aqueous 37% formaldehyde solution and 2.5 g of oxalic acid were supplied into a three-necked flask set in an oil bath, and the mixture was heated with stirring. As violent foaming took place at around 90°C, the mixture was temporarily cooled and then again heated till the internal temperature reached 150°C. After approximately a 3 hour reaction, the mixture was again heated to 175°C and the water was distilled off. 2 hours later, the mixture was further heated to 200°C while reducing the pressure to 100 mmHg and the residual monomers were distilled off. The reaction was stopped 10 minutes later, and the reaction product was flown out into a Teflon butt and solidified. The molecular weight of the obtained resin was determined by the GPC method with polystyrene as a standard. The Mn and Mw were calculated in the same way as described above. The results showed the Mn of the product was 1,350 and the Mw was 6,750.
(Synthesis of photosensitive material)

COMPARATIVE SYNTHESIS EXAMPLE 1a

100 g of pyrogallol and 700 g of acetone were supplied into a three-necked flask set in a water bath. After replacing the flask atmosphere with nitrogen gas, 10 g of phosphorus oxychloride was supplied into the flask to initiate a polycondensation reaction. The reaction was continued for a whole day and night while keeping the reaction temperature at 20°C. Thereafter the reaction product was supplied piecemeal into 30 liters of water with vigorous stirring, causing precipitation of the polycondensate.

The precipitated resin was filtered, washed with water till it became substantially neutral, and then dried at a temperature below 40°C. 100 g of a light-brown resin was obtained.

Determination of the molecular weight of this resin by the GPC method showed Mn = 2,000 and Mw = 3,400.

60 g of this resin was dissolved in 720 ml of dioxane. Then 70 g of 1,2-naphthoquinonediazido-5-sulfonyl chloride was dissolved in the solution, followed by dropwise addition of 60 g of aqueous 13 wt% potassium carbonate to carry out a condensation reaction at 40 to 50°C for about one hour. The resulting reaction solution was supplied into a large amount of a dilute hydrochloric acid (comprising 13 ml of concentrated hydrochloric acid and 3 liters of water). The precipitated resin was filtered and dried. There was thus obtained 56 g of the 1,2-naphthoquinonediazido-5-sulfonic ester of pyrogallol-acetone resin as yellow powder. Analysis showed the condensation rate of the hydroxyl group to be 20%. The molecular weight of this ester product was determined by the GPC method described above and showed Mn = 2,300 and Mw = 3,030.

EXAMPLE 1

A 0.24 mm thick aluminium plate (material: 1050; refining: H 16) was degreased in an aqueous 5 wt% sodium hydroxide solution at 60°C for one minute and then subjected to electrolytic etching in 1 liter of 0.5 mol hydrochloric acid under the conditions of 25°C, 60 A/dm$^2$ (current density) and 30 seconds (treating time). The plate was then subjected to a desmutting treatment in an aqueous 5 wt% sodium hydroxide solution at 60°C for 10 seconds, followed by anodizing in aqueous 20 wt% sulfuric acid solution under the conditions of 20°C, 3 A/dm$^2$ and one minute treatment. The plate was further subjected to a sealing treatment in hot water at 30°C for 20 seconds to make an aluminium support for a planographic printing plate.

The thus obtained aluminium support was rotary coated with a photosensitive coating solution (sensitizing solution 1) of the following composition and dried at 90°C for 4 minutes to make a positive photosensitive planographic printing plate (Sample No. 1).

Sensitizing solution 1

| | |
|---|---|
| Orthoquinonediazido compound (QD-1) | 13 parts |
| High-molecular weight compound (Compound (i) shown below) | 25 parts |
| Succinic acid | 2.3 parts |
| Victoria Pure Blue BOH (made by Hodogaya Chemical Co., Ltd.) | 0.8 part |
| 2-trichloromethyl-5-(β-(2-benzofuryl)vinyl)-1,3,4-oxadiazole | 1.3 parts |
| Methyl cellosolve | 97.5 parts |

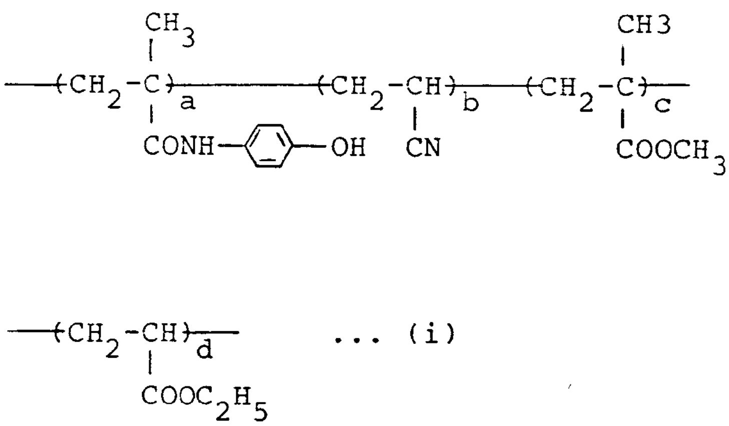

... (i)

(Mw = 20,000, Mw/Mn = 2.1, a:b:c:d = 30:30:36.5:3.5).

A step tablet for determining sensitivity (Eastman Kodak Step Tablet No. 2, 21-step gray scale with a density difference of 0.15 from one step to another) was attached to the surface of the photosensitive layer of the sample and then the sample was exposed at a light intensity of 8.0 $mW/cm^2$ using a 2 kW metal halide lamp as light source. This sample printing plate was then developed with a developer SDR-1 (available from Konica Corporation) diluted 6 times with water (hereinafter referred to as standard developer) at 25°C. The sensitivity was indicated by the exposure time required till step four of the step tablet became perfectly clear.

To determine underdevelopability, developability with developers with diluted alkali densities, namely developers with reduced developing performance, was evaluated. Said developability was evaluated by two methods. In one method, development was conducted at 25°C for 40 seconds changing the dilution of SDR-1 to 11 times and 13 times and then the non-image area was erased with an eraser SIR-15 (available from Konica Corporation), followed by inking. In the other method, halftone dots were developed and these parts were inked likewise.

For determining the chemical resistance of the printing plate, its durability against Ultra Plate Cleaner (made by A.B.C. Chemicals Corp.), a cleaner used for removing scum formed on the non-image area during printing, and developing ink SPO-1 (made by Konica Corporation), an ink used for development inking, was examined. The image-formed printing plate was immersed in each of the treating solutions at room temperature for a predetermined period of time and, after washing with water, the image area of the printing plate was compared with that before immersion to judge the degree of corrosion of the image area by the treating chemicals.

Next, the printing test was carried out on the printing plate. Printing was carried out with the printing plate by using DIC Dai-Cure Process Red Ink (available from Dai Nippon Ink & Chemical Industries Co., Ltd.) and

cleaning the plate surface with Ultra Plate Cleaner (A.B.C. Chemical Corp.) upon printing every 5,000 copies. Evaluation was made by printing a total of 30,000 copies.

Scumming-recovery on the press was also evaluated by the number of copies printed till the ink was removed from the non-image area in a printing operation in which ink was applied onto the entire surface of the printing plate without giving water and then water was given to the plate surface. The smaller the number of copies printed till the ink was removed from the non-image area, the better the scumming-recovery of the printing plate.

Overdevelopability was evaluated by determining the difference between the number of solid steps (the minimum number of steps where the photosensitive layer remains in the gray scale of the step tablet) when using a developer obtained by adding 0.2 liters or 0.5 litres of a 4 times diluted solution of SDR-1 to 9.0 liters of the standard developer and the number of solid steps when using the standard developer. The smaller the difference, the better the overdevelopability.

The results of these evaluations are shown in Table 1, on the first lateral column under Sample No.1.

Planographic printing plates, Samples Nos. 2-14, were made in the same way as Sample No. 1 except that at least one of the components orthoquinonediazido compound (QD-1), high-molecular weight compound (i) and succinic acid (used as organic acid) of the photosensitive coating solution was changed as shown in Table 1 and that, in some cases, no high-molecular weight compound was added or a novolak resin was added. These printing plates were subjected to the same evaluations as conducted on Sample No. 1, obtaining the results shown in Table 1.

Table 1

| Sample No. | *1 o-quinone-diazido compound | High-molecular | *2 Novolak resin weight compound | Organic acid | pKa | *5 Underdevelop-ability | | Sensi-tivity (s) | *6 Chemical resistance | | Scumming-recovery (No. of copies) | Printing durability (No. of copies) | Overdeve-lopability | |
|---|---|---|---|---|---|---|---|---|---|---|---|---|---|---|
| | | | | | | Diluted 11 times | Diluted 13 times | | UPC *7 | PI-2 | | | 0.2ℓ | 0.5ℓ |
| 1 | QD-1 | (i) | - | Succinic acid | 4.2 | A | A | 50 | o | o | 35 | Over 30,000 | 1.5 | 2.5 |
| 2 | QD-1 | (ii) | - | Glutaric acid | 4.3 | A | A | 45 | o | o | 40 | " | 1.5 | 2.5 |
| 3 | QD-1 | (iii) | - | Adipic acid | 4.4 | A | A | 45 | o | o | 37 | " | 1.5 | 2.0 |
| 4 | QD-1 | (i) | *3 | Ascorbic acid | 4.2 | A | A | 60 | o | o | 49 | " | 1.0 | 1.5 |
| 5 | QD-2 | (ii) | - | Merdrum acid | 5.1 | A | A | 45 | o | o | 40 | " | 1.5 | 2.0 |
| 6 | QD-2 | (iii) | *3 | Glutaric acid | 4.3 | A | A | 50 | o | o | 38 | " | 1.0 | 1.5 |
| 7 | QD-1 | (i) | - | Malonic acid | 2.8 | A | A | 50 | o | o | 41 | " | 1.5 | 2.0 |
| 8 | QD-1 | - | *4 | p-toluenesul-fonic acid | below 1.0 | C | D | 90 | x | x | 97 | About 5,000 | 1.5 | 2.0 |
| 9 | QD-1 | - | *4 | Diphenyl phosphate | below 1.0 | C | D | 100 | x | x | 100 | " | 1.5 | 2.0 |
| 10 | QD-2 | - | *4 | Picric acid | 0.7 | C | D | 100 | x | x | 101 | " | 1.5 | 2.0 |
| 11 | QD-2 | (iii) | - | Picric acid | 0.7 | C | D | 100 | o | o | 112 | Over 30,000 | 1.5 | 2.5 |
| 12 | QD-2 | - | *4 | - | - | D | D | 120 | x | x | 115 | About 5,000 | 1.5 | 2.0 |
| 13 | QD-2 | - | *4 | 2,3-dinitro-benzoic acid | 1.9 | C | D | 90 | x | x | 110 | " | 1.5 | 2.0 |
| 14 | QD-2 | - | *4 | Malonic acid | 2.8 | B | B | 80 | x | x | 80 | " | 1.5 | 2.0 |

*1 o-quinonediazido compound;
QD-1: 1,2-naphthoquinonediazido-5-sulfonic acid-2,3,4-trihydroxybenzophenone ester,
QD-2: esterification product of pyrogallol-acetone condensate resin (Mw= 1,800) and 1,2-naphthoquinone-diazido-5-sulfonyl chloride.

*2 Novolak resin
Co-condensate resin of m-cresol, p-cresol and formaldehyde.

*3 Added in an amount of 10% by weight of high-molecular compound.

*4 Added in the same amount as high-molecular compound of samples Nos. 1-7.

*5 Underdevelopability
A: No scumming.
B: Slight scumming occured.
C: Scumming occured noticeably.
D: Scumming occured excessively.

*6 Chemical resistance
o: No corrosion of image area was seen.
x: Extensive corrosion of image area was seen.
UPC: Immersed for 2 hours.
PI-2: Immersed for 30 minutes.

*7 UPC: Ultra Plate Cleaner.

In the above table, high-molecular weight compound (ii) is a compound of formula:

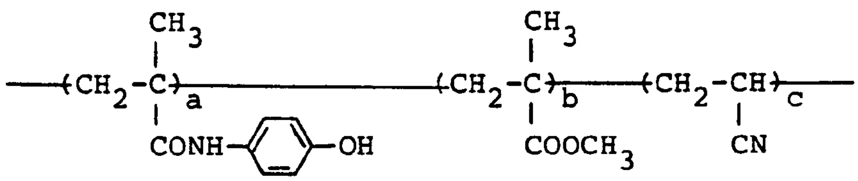

(Mw = 22,000, Mw/Mn = 6.9, a:b:c = 30:40:30), and high-molecular weight compound (iii) is a compound of formula:

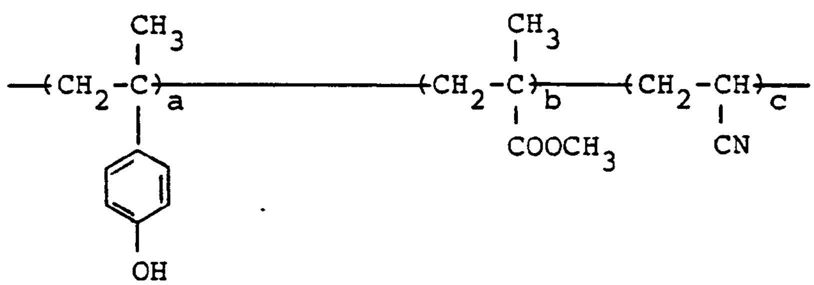

(Mw = 54,000, Mw/Mn = 8.2, a:b:c = 20:40:40).

As seen from Table 1, it is possible, with the photosensitive planographic printing plates of this invention, to obtain clear prints without causing disappearance of the dots at the highlights of the image area even after 30,000 copies have been printed. On the other hand, in the case of the printing plates prepared as comparative examples, except for Sample No. 11, ink adhesiveness at the image area deteriorated and also the dots at the highlights disappeared after cleaning of the plate surface on printing 5,000 copies, making it impossible to obtain clear prints after printing about 5,000 copies. The printing plate of Sample No. 11 was also unsatisfactory in underdevelopability, sensitivity and scumming-recovery.

It was also found that the photosensitive planographic printing plates of this invention had excellent underdevelopability, sensitivity, chemical resistance and scumming-recovery characteristics.

## EXAMPLE 2

An aluminium plate to be used as support for a planographic printing plate was made by following the procedure of Example 1.

This aluminium plate was rotary coated with a photosensitive coating solution (sensitizing solution 2) of the following composition and dried at 90°C for 4 minutes to obtain a positive photosensitive planographic printing plate (Sample No. 15).

Sensitizing solution 2

| | |
|---|---|
| High-molecular weight compound (iv) | 48 parts (53.3 parts in the case of Sample No. 35) |
| Novolak resin (A) | 5.3 parts (53.3 parts in the case of Sample No. 36) |
| o-quinonediazido compound (QD-1) | 12 parts |
| Compound having the structural unit (II) or (III) (Emulgen 906) | 3.3 parts |
| Victoria Pure Blue BOH (made by Hodogaya Chemical Co., Ltd.) | 0.7 part |
| 2-trichloromethyl-5-(β-(2-benzofuryl)-vinyl)-1,3,4-oxadiazole | 1.3 parts |
| Methyl cellosolve | 975 parts |

Additional photosensitive planographic printing plates (Samples Nos. 16-36) were made by the same method as used for Sample No. 15 except that at least one of the components o-quinonediazido compound, novolak resin, high-molecular weight compound and compound having the structural unit (II) or (III) in said sensitizing solution was changed as shown in Table 2.

A step tablet for determining sensitivity (Eastman Kodak Step Tablet No. 2, a 21-step gray scale with a stepwise density difference of 0.15) was attached to each of the sample photosensitive planographic printing plates (Samples Nos. 15-36), and each sample was exposed at a light intensity of 8.0 mW/cm$^2$ using a 2 kW metal halide lamp. They were then developed with the standard developer prepared by diluting SDR-1 6 times with water, at 25°C for 40 seconds, whereby the non-image area was perfectly removed to give planographic printing plates.

In order to determine the overdevelopability, there was prepared a developer having an excess developing capacity by adding a 4 times diluted solution of SDR-1R (a developer replenisher available from Konica Corporation) to the standard developer. The exposed samples were developed with this developer at 25°C for 40 seconds, and their overdevelopability was judged by observing the increase of the number of solid steps in the step tablet in comparison with standard development. The smaller the increase of the number of solid steps, the better the overdevelopability.

For determining the safe-light tolerance, each sample was exposed to white fluorescent light for 10 minutes or 15 minutes and then developed with the standard developer at 25°C for 40 seconds, and the degree of corrosion at the exposed portion was examined.

Ballpen performance of each specimen was determined by drawing on the non-exposed portion with a Pilot ballpen, developing the specimen with the standard developer at 25°C for 60 seconds and visually judging the degree of corrosion of the drawing portion.

Chemical resistance of the samples was determined by examining their proofness against Ultra Plate Cleaner (made by A.B.C. Chemical Co., Ltd.) used as a cleaner for removing scum formed on the non-image area during printing. The image-formed printing plate was immersed in each of the treating solutions at room temperature for a predetermined period of time and then washed with water and the image area was compared with that before immersion to judge the degree of corrosion of the image area by the treating chemicals.

A printing test was conducted by using a press, in which ink adhesiveness was evaluated by the number of copies printed till the ink was perfectly transferred to the printing paper after the start of printing.

The results are shown in Table 2.

Table 2

| Sample No. | *1 o-quinone-diazido compound | *2 Novolak resin | *3 High-molecular weight compound | *4 Compound having structure unit (II) or (III) | *5 Overdevelopability (Increase of the number of solid steps based on standard development | | | *6 Safe-light tolerance | | *6 Ballpen perfor-mance | *6 Chemical re-sistance | Ink adhesive-ness (No. of copies) |
|---|---|---|---|---|---|---|---|---|---|---|---|---|
| | | | | | Over 1 | Over 2 | Over 3 | 10 min | 15 min | | | |
| 15 | QD-1 | A | (iv) | Emulgen 906 | 1.0 | 2.0 | 2.5 | A | B | A | A | 3 |
| 16 | QD-1 | A | (iv) | Emulgen 910 | 1.0 | 1.5 | 2.5 | A | B | A | A | 4 |
| 17 | QD-1 | A | (iv) | Emulgen 920 | 1.0 | 1.5 | 2.0 | A | B | A | A | 4 |
| 18 | QD-1 | A | (iv) | Emulgen 930 | 1.0 | 2.0 | 2.5 | A | B | A | A | 5 |
| 19 | QD-1 | A | (iv) | Emulgen 950 | 1.0 | 1.5 | 2.0 | A | B | A | A | 4 |
| 20 | QD-1 | A | (iv) | Emulgen 120 | 1.0 | 1.5 | 2.5 | A | B | A | A | 3 |
| 21 | QD-1 | A | (iv) | Emulgen PP-250 | 1.0 | 1.5 | 2.5 | A | B | A | A | 3 |
| 22 | QD-1 | A | (iv) | Leodol TW-S 120 | 1.0 | 2.0 | 2.5 | A | B | A | A | 4 |
| 23 | QD-1 | A | (iv) | Leodol TW-O 106 | 1.0 | 1.5 | 2.0 | A | B | A | A | 4 |
| 24 | QD-1 | A | (iv) | Emanone 1112 | 1.0 | 1.5 | 2.5 | A | B | A | A | 3 |
| 25 | QD-1 | A | (iv) | Polyethylene glycol | 1.0 | 1.5 | 2.0 | A | B | A | A | 5 |
| 26 | QD-1 | A | (iv) | Tetraethylene glycol | 1.0 | 2.0 | 2.5 | A | B | A | A | 4 |
| 27 | QD-1 | A | (iv) | FC-430 | 1.0 | 1.5 | 2.0 | A | B | A | A | 3 |
| 28 | QD-1 | A | (iv) | Newpol BTE-60 | 1.0 | 1.5 | 2.0 | A | B | A | A | 5 |
| 29 | QD-1 | A | (iv) | Nikkol R-1020 | 1.0 | 1.5 | 2.5 | A | B | A | A | 4 |
| 30 | QD-3 | B | (iv) | Emulgen 920 | 2.0 | 3.0 | 5.0 | A | B | D | A | 4 |
| 31 | QD-4 | B | (iv) | Emulgen 920 | 1.5 | 3.0 | 5.5 | A | B | D | A | 3 |
| 32 | QD-5 | B | (iv) | Polyethylene glycol | 1.0 | 2.0 | 4.5 | A | B | C | A | 3 |
| 33 | QD-6 | B | (iv) | Polyethylene glycol | 1.0 | 1.5 | 4.5 | A | B | C | A | 4 |
| 34 | QD-1 | A | (vi) | - | 1.5 | 3.0 | 4.5 | B | D | C | C | 4 |
| 35 | QD-1 | - | (iv) | Polyethylene glycol | 1.5 | 2.0 | 3.0 | A | B | A | A | 4 |
| 36 | QD-1 | B | (v) | Emulgen 920 | 1.5 | 2.5 | 5.0 | B | D | B | C | 3 |

In Table 2;

*1 o-quinonediazido compound:

QD-1: 1,2-naphthoquinonediazido-5-sulfonic acid-2,3,4-trihydroxybenzophenone ester,
QD-3: 1,2-naphthoquinonediazido-5-sulfonic acid-4-hydroxybenzoic acid ethyl ester,
QD-4: 1,2-naphthoquinonediazido-5-sulfonic acid-bisphenol A monoester,
QD-5:

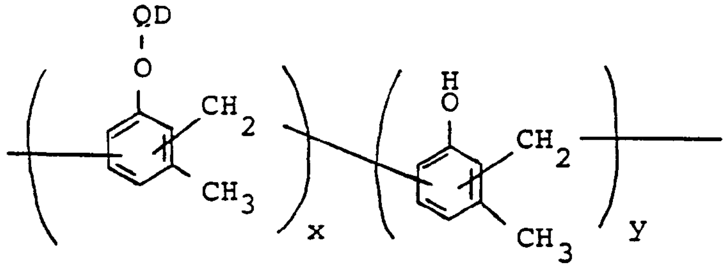

wherein QD =

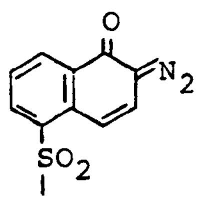

(x/y = 1/3; Mw of the resin before reacted with QD = 1,600), and

QD-6:

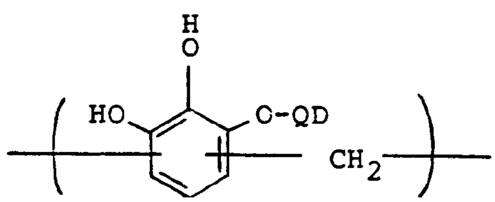

(Mw of the resin before reacted with QD = 1,000).

*2 Novolak resin:

Novolak resin (A):
co-condensation polymerization resin of phenol, m-cresol, p-cresol and formaldehyde (phenol:m-cresol:p-cresol (molar ratio) = 2.0:4.8:3.2; Mw = 7,000, Mw/Mn = 5.8),

Novolak resin (B):
co-condensation polymerization resin of m-cresol, p-cresol and formaldehyde (m-cresol:p-cresol (molar ratio) = 6:4; Mw = 8,000, Mw/Mn = 6.0).

*3 High-molecular weight compound:

High-molecular weight compound (iv):

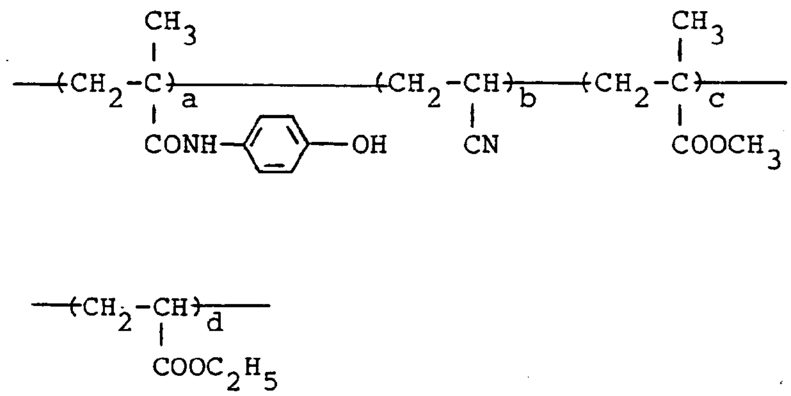

(Mw = 20,000, Mw/Mn = 2.1, a:b:c:d = 30:30:36.5:3.5),
High-molecular weight compound (v):

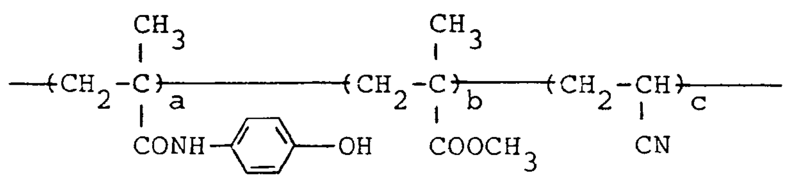

(Mw = 22,000, Mw/Mn = 6.9, a:b:c = 30:40:30),
High-molecular weight compound (vi):

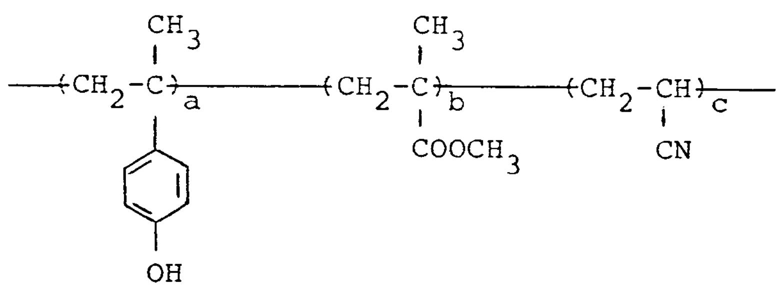

(Mw = 54,000, Mw/Mn = 8.2, a:b:c = 20:40:40).

*4 Compound having structural unit (II) or (III):

Emulgen 120 (made by Kao Co., Ltd.):
polyoxyethylene lauryl ether,

Emulgen 906 (Kao)
Emulgen 910 (Kao)
Emulgen 920 (Kao)
Emulgen 930 (Kao)
Emulgen 950 (Kao)
} polyoxyethylene nonylphenyl ether,

Emulgen PP-250 (Kao):
oxyethylene-oxypropylene block copolymer,

Leodol TW-S 120 (Kao):
polyoxyethylene sorbitan monostearate,
Leodol TW-O 106 (Kao):
polyoxyethylene sorbitan monooleate,
Emanone 1112 (Kao):
polyethylene glycol monolaurate,
Newpol BPE 100 (made by Sanyo Kasei Kogyo KK):

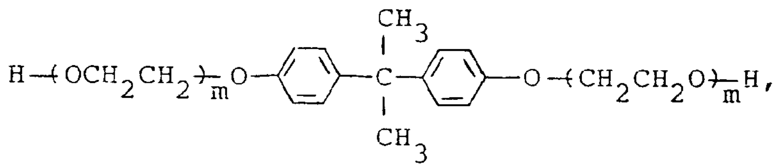

Nikkol R-1020 (made by Nikko Chemicals Co., Ltd.):
polyoxyethylene nonylphenylformaldehyde condensate,
Polyethylene glycol (made by Kanto Chemical Co., Ltd.):
polyethylene glycol #2000, and
FC-430 (made by Sumitomo 3M).

*5 Overdevelopability:

Data obtained by carrying out development with the developers prepared by adding SDR-1R (diluted 4 times) in amounts shown below to 9.0 liters of standard developer,
Over 1: 0.2 liters; Over 2: 0.5 liters; Over 3: 1.0 litre.

*6 Safe-light tolerance, ballpen performance and chemical resistance:

A: No corrosion of image area was seen,
B: Image area was slightly corroded,
C: Image area was noticeably corroded, and
D: Image area was heavily corroded.

It is seen from Table 2 that the photosensitive planographic printing plate samples of the invention containing an o-quinonediazido compound, a novolak resin, a high-molecular weight compound and a compound having the structural unit (II) or (III) have excellent overdevelopability, safe-light tolerance, ballpen performance and ink adhesiveness as well as high chemical resistance.

As described above, the photosensitive planographic printing plate of the invention has good UV ink suitability, great latitude in development, excellent ballpen performance, high chemical resistance and fine sensitivity.

## Claims

1. A positive photosensitive planographic printing plate comprising, on a support, a photosensitive layer comprising:
(A) the o-naphthoquinonediazidosulfonic ester of a polyhydroxybenzophenone, or derivative thereof;
(B) a high-molecular weight compound comprising structural units of formula (I):

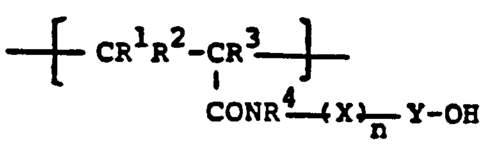

(I)

wherein:
$R^1$ and $R^2$ are each, independently, hydrogen, a halogen or an alkyl, aryl or carboxyl group;
$R^3$ is hydrogen, a halogen or an alkyl or aryl group;

$R^4$ is hydrogen, or an alkyl, aryl or aralkyl group;

Y is an optionally substituted aromatic group, a carbon atom of which is attached to X if n is not 0;

X is a divalent organic group; and

n is an integer of from 0 to 5; or

a high molecular weight compound of formula:

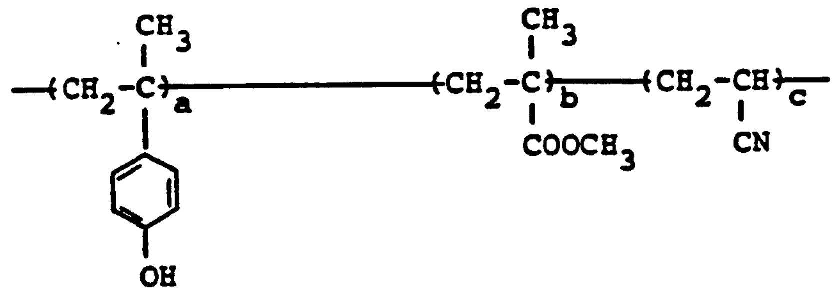

wherein a:b:c = 20:40:40, Mw is 54,000 and Mw/Mn is 8.2; and

(C) a compound comprising from 2 to 5,000 units of at least one of the units of formulae (II) and (III) and/or an organic acid having a pKa of at least 2:

$$-(CH_2CH_2O)- \qquad (II)$$

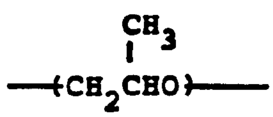

(III)

2. A printing plate according to claim 1 wherein the polyhydroxybenzophenone is dihydroxybenzophenone, trihydroxybenzophenone, tetrahydroxybenzophenone, pentahydroxybenzophenone, octahydroxybenzophenone, or a derivative thereof.

3. A printing plate according to claim 1 or 2 wherein:
   $R^1$ and $R^2$ are each, independently, hydrogen or an alkyl or carboxyl group;
   $R^3$ is hydrogen, a halogen or an alkyl group;
   $R^4$ is hydrogen or an alkyl group;
   Y is an optionally substituted phenylene or naphthylene group;
   X is an alkylene group; and
   n is an integer of from 0 to 3.

4. A printing plate according to any one of claims 1 to 3 wherein the high-molecular weight compound has a weight-average molecular weight of from 5,000 to 100,000 and comprises at least 10 mole percent of structural units of formula (I).

5. A printing plate according to any one of claims 1 to 4 wherein the high-molecular weight compound additionally comprises units derived from at least one of a methacrylic acid, acrylic acid, ester of an aliphatic monocarboxylic acid or nitrile.

6. A printing plate according to any one of claims 1 to 5 wherein the photosensitive layer comprises from 5 to 50% by weight of the ester (A) and from 50 to 95% by weight of the high-molecular weight compound.

7. A printing plate according to any one of claims 1 to 6 wherein the photosensitive layer comprises from 0.2 to 10% by weight of the compound comprising at least one of the structural units of formulae (II) and (III).

8. A printing plate according to any one of claims 1 to 7 wherein the photosensitive layer further comprises a novolak resin.

9. A printing plate according to claim 8 wherein the novolak resin is obtainable by co-condensation polymerization of at least one of a phenol, m-cresol, o-cresol or p-cresol, and formaldehyde.

**10.** A printing plate according to claim 8 or 9 wherein the novolak resin has a weight-average molecular weight of from 1,000 to 30,000 and a number-average molecular weight of from 300 to 7,500.

**11.** A printing plate according to any one of claims 8 to 10 wherein the photosensitive layer comprises from 5 to 50% by weight of the ester (A), from 45 to 95% by weight of the high-molecular weight compound and from 0.01 to 50% by weight of the novolak resin.

**12.** A printing plate according to any one of claims 1 to 11 wherein the photosensitive layer further comprises an organic acid having a pKa of at least 2.

**13.** A printing plate according to any one of claims 1 to 12 wherein the photosensitive layer comprises from 5 to 50% by weight of the ester (A), from 50 to 95% by weight of the high-molecular weight compound and from 0.05 to 10% by weight of the organic acid.

**14.** A printing plate according to any one of claims 1 to 13 wherein the remainder of the photosensitive layer comprises at least one of an image-additive after exposure, pigment, surface active agent, sensitizer, plasticizer or additive having a hydrophobic group.

**15.** A printing plate according to any one of claims 5 to 14 wherein the high molecular weight compound is a random or block copolymer of formula:

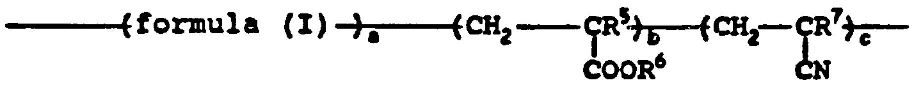

wherein formula (I) is as defined in claim 1; $R^5$, $R^6$ and $R^7$ are each independently hydrogen, a halogen or alkyl; and a, b and c are each independently 10 to 60 mol%.

## Patentansprüche

**1.** Lichtempfindliche positive Flachdruckplatte, die auf einem Träger eine lichtempfindliche Schicht umfaßt, wobei die lichtempfindliche Schicht

(A) den o-Naphthochinondiazidosulfonsäureester eines Polyhydroxybenzophenons oder ein Derivat davon;

(B) eine Verbindung mit hohem Molekulargewicht, die Struktureinheiten der Formel (I) enthält,

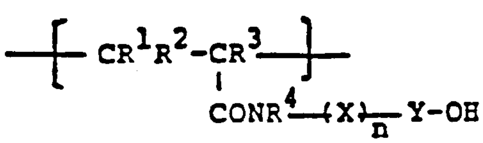 (I)

worin

$R^1$ und $R^2$ jeweils unabhängig voneinander Wasserstoff, ein Halogen oder eine Alkyl-, Aryl- oder Carboxylgruppe sind;

$R^3$ ein Wasserstoff, ein Halogen oder eine Alkyl- oder Arylgruppe ist;

$R^4$ Wasserstoff oder eine Alkyl-, Aryl- oder Aralkylgruppe ist;

Y eine wahlweise substituierte aromatische Gruppe ist, von der ein Kohlenstoffatom an X gebunden ist, wenn n nicht gleich 0 ist;

X eine divalente organische Gruppe ist; und

n eine ganze Zahl von 0 bis 5 ist; oder

eine Verbindung mit hohem Molekulargewicht der Formel

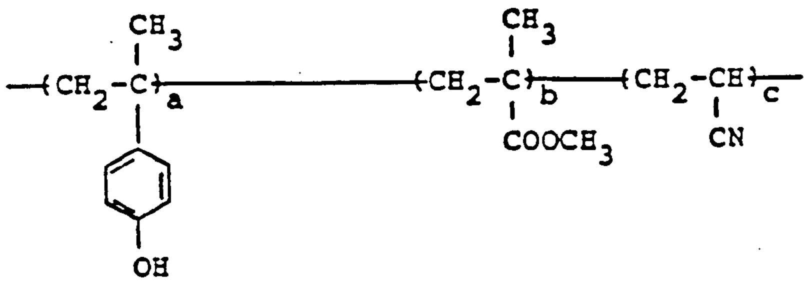

enthält,
wobei a:b:c = 20:40:40; das Gewichtsmittel des Molekulargewichts (Mw) 54000 und das Verhältnis Gewichtsmittel des Molekulargewichts zu Zahlenmittel des Molekulargewichts (Mw/Mn) 8,2 ist; und
(C) eine Verbindung, die 2 bis 5000 Einheiten mindestens einer der Einheiten der Formeln (II) und (III) und/oder eine organische Säure mit einem pKa von mindestens 2 umfaßt:

$$-(CH_2CH_2O)- \quad \text{(II)}$$

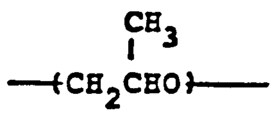

(III)

enthält.

2. Druckplatte nach Anspruch 1, bei der das Polyhydroxybenzophenon Dihydroxybenzophenon, Trihydroxybenzophenon, Tetrahydroxybenzophenon, Pentahydroxybenzophenon, Octahydroxybenzophenon oder ein Derivat der genannten ist.

3. Druckplatte nach Anspruch 1 oder 2, wobei
$R^1$ und $R^2$ jeweils unabhängig voneinander Wasserstoff oder eine Alkyl- oder Carboxylgruppe sind;
$R^3$ Wasserstoff, ein Halogen oder eine Alkylgruppe ist;
$R^4$ Wasserstoff oder eine Alkylgruppe ist;
Y eine wahlweise substituierte Phenylen- oder Naphthylengruppe ist;
X eine Alkylengruppe ist; und
n eine ganze Zahl von 0 bis 3 ist.

4. Druckplatte nach einem der Ansprüche 1 bis 3, wobei die Verbindung mit hohem Molekulargewicht ein Gewichtsmittel des Molekulargewichts im Bereich von 5000 bis 100000 aufweist und mindestens 10 Mol% Struktureinheiten der Formel (I) enthält.

5. Druckplatte nach einem der Ansprüche 1 bis 4, wobei die Verbindung mit hohem Molekulargewicht zusätzlich Einheiten enthält, die von mindestens einer der Verbindungen Methacrylsäure, Acrylsäure, Ester einer aliphatischen Monocarbonsäure oder Nitril abgeleitet sind.

6. Druckplatte nach einem der Ansprüche 1 bis 5, wobei die lichtempfindliche Schicht 5 bis 50 Gew.% Ester (A) und 50 bis 95 Gew.% der Verbindung mit hohem Molekulargewicht enthält.

7. Druckplatte nach einem der Ansprüche 1 bis 6, wobei die lichtempfindliche Schicht 0,2 bis 10 Gew.% der Verbindung enthält, die mindestens eine der Struktureinheiten der Formeln (II) und (III) umfaßt.

8. Druckplatte nach einem der Ansprüche 1 bis 7, wobei die lichtempfindliche Schicht außerdem ein Novolakharz enthält.

9. Druckplatte nach Anspruch 8, wobei das Novolakharz durch Ko-Kondensationspolymerisation mindestens einer der Verbindungen: ein Phenol, m-Kresol, o-Kresol oder p-Kresol mit Formaldehyd erhältlich ist.

10. Druckplatte nach Anspruch 8 oder 9, wobei das Novolakharz ein Gewichtsmittel des Molekulargewichts

von 1000 bis 30000 und ein Zahlenmittel des Molekulargewichts von 300 bis 7500 aufweist.

**11.** Druckplatte nach einem der Ansprüche 8 bis 10, wobei die lichtempfindliche Schicht 5 bis 50 Gew.% Ester (A), 45 bis 95 Gew.% der Verbindung mit hohem Molekulargewicht und 0,01 bis 50 Gew.% Novolakharz enthält.

**12.** Druckplatte nach einem der Ansprüche 1 bis 11, wobei die lichtempfindliche Schicht außerdem eine organische Säure mit einem pKa von mindestens 2 enthält.

**13.** Druckplatte nach einem der Ansprüche 1 bis 12, wobei die lichtempfindliche Schicht 5 bis 50 Gew.% Ester (A), 50 bis 95 Gew.% der Verbindung mit hohem Molekulargewicht und 0,05 bis 10 Gew.% der organischen Säure enthält.

**14.** Druckplatte nach einem der Ansprüche 1 bis 13, wobei der Rest der lichtempfindlichen Schicht mindestens eins der folgenden Mittel: ein Bild-Zusatzstoff nach Belichtung, Pigment, oberflächenaktives Mittel, Sensibilisator, Weichmacher oder ein Zusatzstoff mit einer hydrophoben Gruppe enthält.

**15.** Druckplatte nach einem der Ansprüche 5 bis 14, wobei die Verbindung mit hohem Molekulargewicht eins statistisches oder ein Block-Copolymer der Formel

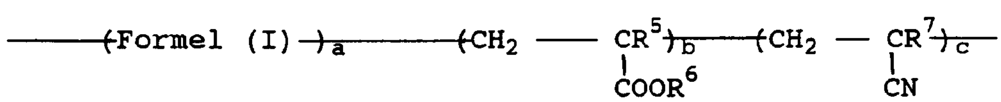

ist, worin Formel (I) wie in Anspruch 1 definiert ist;
$R^5$, $R^6$ und $R^7$ jeweils unabhängig voneinander Wasserstoff, ein Halogen oder Alkyl sind; und a, b und c jeweils unabhängig voneinander 10 bis 60 Mol% sind.

## Revendications

**1.** Plaque d'impression lithographique photosensible positive comprenant, sur un support, une couche photosensible comprenant:

(A) l'ester o-naphtoquinonediazidosulfonique d'une polyhydroxybenzophénone, ou un de ses dérivés; et

(B) un composé de masse moléculaire élevée comprenant des motifs constitutifs de formule (I):

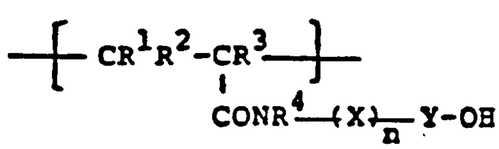

(I)

dans laquelle:

R1 et $R^2$ sont chacun, indépendamment, un atome d'hydrogène, un atome d'halogène ou un groupe alkyle, aryle ou carboxyle;

$R^3$ est un atome d'hydrogène, un atome d'halogène ou un groupe alkyle ou aryle;

$R^4$ est un atome d'hydrogène ou un groupe alkyle, aryle ou arylalkyle;

Y est un groupe aromatique éventuellement substitué, dont un atome de carbone est fixé à X si n n'est pas nul;

X est un groupe organique divalent; et

n est un nombre entier de 0 à 5; ou

un composé de masse moléculaire élevée de formule:

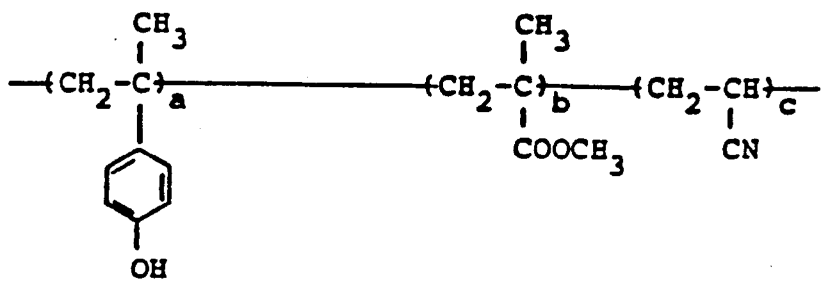

dans laquelle a:b:c = 20:40:40, la masse moléculaire est de 54 000 et le rapport Mp/Mn est de 8,2; et (C) un composé comprenant de 2 à 5 000 motifs d'au moins un des motifs de formules (II) et (III) et/ou un acide organique ayant un pKa d'au moins 2:

$$-(CH_2CH_2O)- \quad (II)$$

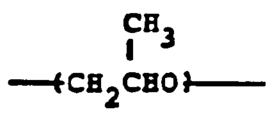 (III)

2. Plaque d'impression selon la revendication 1, dans laquelle la polyhydroxybenzophénone est une dihydroxybenzophénone, une trihydroxybenzophénone, une tétrahydroxybenzophénone, une pentahydroxybenzophénone, une octahydroxybenzophénone, ou un de leurs dérivés.

3. Plaque d'impression selon la revendication 1 ou 2, dans laquelle:
   - $R^1$ et $R^2$ sont chacun, indépendamment, un atome d'hydrogène ou un groupe alkyle ou carboxyle;
   - $R^3$ est un atome d'hydrogène, un atome d'halogène ou un groupe alkyle;
   - $R^4$ est un atome d'hydrogène ou un groupe alkyle;
   - Y est un groupe phénylène ou naphtylène éventuellement substitué;
   - X est un groupe alkylène; et
   - n est un nombre entier de 0 à 3.

4. Plaque d'impression selon l'une quelconque des revendications 1 à 3, dans laquelle le composé de masse moléculaire élevée possède une masse moléculaire moyenne en poids de 5 000 à 100 000 et comprend au moins 10% en moles de motifs constitutifs de formule (I).

5. Plaque d'impression selon l'une quelconque des revendications 1 à 4, dans laquelle le composé de masse moléculaire élevée comprend aussi des motifs dérivés de l'un au moins des composés acide méthacrylique, acide acrylique, ester d'acide monocarboxylique aliphatique ou nitrile.

6. Plaque d'impression selon l'une quelconque des revendications 1 à 5, dans laquelle la couche photosensible comprend de 5 à 50% en poids de l'ester (A) et de 50 à 95% en poids du composé de masse moléculaire élevée.

7. Plaque d'impression selon l'une quelconque des revendications 1 à 6, dans laquelle la couche photosensible comprend de 0,2 à 10% en poids du composé comprenant au moins un des motifs constitutifs de formules (II) et (III).

8. Plaque d'impression selon l'une quelconque des revendications 1 à 7, dans laquelle la couche photosensible comprend aussi une résine novolaque.

9. Plaque d'impression selon la revendication 8, dans laquelle on peut obtenir la résine novolaque par polymérisation par co-condensation d'au moins un des composés phénol, m-crésol, o-crésol ou p-crésol avec du formaldéhyde.

10. Plaque d'impression selon la revendication 8 ou 9, dans laquelle la résine novolaque possède une masse moléculaire moyenne en poids de 1 000 à 30 000 et une masse moléculaire moyenne en nombre de 300 à 7 500.

**11.** Plaque d'impression selon l'une quelconque des revendications 8 à 10, dans laquelle la couche photosensible comprend de 5 à 50% en poids de l'ester (A), de 45 à 95% en poids du composé de masse moléculaire élevée et de 0,01 à 50% en poids de la résine novolaque.

**12.** Plaque d'impression selon l'une quelconque des revendications 1 à 11, dans laquelle la couche photosensible comprend aussi un acide organique ayant un pKa d'au moins 2.

**13.** Plaque d'impression selon l'une quelconque des revendications 1 à 12, dans laquelle la couche photosensible comprend de 5 à 50% en poids de l'ester (A), de 50 à 95% en poids du composé de masse moléculaire élevée et de 0,05 à 10% en poids de l'acide organique.

**14.** Plaque d'impression selon l'une quelconque des revendications 1 à 13, dans laquelle le reste de la couche photosensible comprend au moins un additif d'image après exposition, un pigment, un agent tensioactif, un sensibilisateur, un plastifiant ou un additif comportant un groupe hydrophobe.

**15.** Plaque d'impression selon l'une quelconque des revendications 1 à 14, dans laquelle le composé de masse moléculaire élevée est un copolymère statistique ou séquencé de formule:

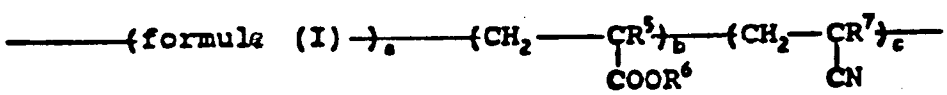

dans laquelle la formule (I) est telle que définie dans la revendication 1; $R^5$, $R^6$ et $R^7$ sont chacun indépendamment un atome d'hydrogène, un atome d'halogène ou un groupe alkyle; et a, b et c sont chacun indépendamment 10 à 60% en moles.